# EUROPEAN PATENT APPLICATION

(11) **EP 2 123 732 A1**
(43) Date of publication of application: **25.11.2009**
(21) Application number: 08712057.2
(22) Date of filing: 27.02.2008
(51) Int. Cl.: C09K 11/06, H01L 51/50, H05B 33/10, C07C 15/20, C07C 211/57

(54) **ORGANIC EL MATERIAL-CONTAINING SOLUTION, METHOD FOR FORMING ORGANIC EL THIN FILM, AND ORGANIC EL DEVICE**

(30) Priority: 28.02.2007 JP 2007050858
(71) Applicant: Idemitsu Kosan Co., Ltd., Chiyoda-ku Tokyo 100-8321 (JP)
(72) Inventor: INOUE, Tetsuya, Sodegaura-shi Chiba 299-0293 (JP); FUKUDA, Masahiko, Sodegaura-shi Chiba 2990293 (JP); TAKESHIMA, Motohiro, Sodegaura-shi Chiba 299-0293 (JP); HOSOKAWA, Chishio, Sodegaura-shi Chiba 299-0293 (JP)
(74) Representative: Gille Hrabal Struck Neidlein Prop Roos
(86) International application number: PCT/JP2008/053435
(87) International publication number: WO 2008/105471

(57) **Abstract**

An organic luminescent material-containing solution contains an organic electroluminescent material and a solvent. The organic electroluminescent material at least contains a host and dopant, and the host is an anthracene derivative. The host is dissolved in the solvent with a content of 0.5 weight percent or more while the solvent exhibits viscosity of 5cP or more. The solvent contains an alkyl-substituted biphenyl that has an alkyl group having 1 to 10 carbon atoms as a substituent.

## Description

### TECHNICAL FIELD

The present invention relates to organic electroluminescent material-containing solution, a method of forming organic electroluminescent thin film(s) and an organic electroluminescence device. The present invention more particularly relates to organic electroluminescent material-containing solution used for forming organic thin film(s) included in an organic electroluminescence device by coating method, a method of forming the thin film(s) using the solution, and an organic electroluminescence device including the organic electroluminescent thin film(s) formed by the method.

### BACKGROUND ART

Such an organic electroluminescence as described below has been conventionally known.
An organic electroluminescence device is a self-emitting device that is based on a principle according to which, with an electric filed applied, fluorescent material emits light by recombination energy caused by holes injected from an anode and electrons injected from a cathode.

A low-molecular organic electroluminescent material has been known as a material for forming such an electroluminescence device.
Known examples of the low-molecular organic electroluminescence material are a chelate complex (e.g. a tris(8-quinolinol) aluminum complex), a coumarin complex, a tetraphenyl butadiene derivative, a bisstyrylarylene derivative and an oxadiazole derivative, all of which are reported to emit light of blue to red in visible region. Thus, such a material is expected to be applied to a color display device.

Vacuum deposition is employed for forming thin films using the low-molecular organic electroluminescent material. By sublimating the material with favorable thermal stability and vapor-deposing the material on a substrate, an organic electroluminescence device of high performance is obtained (e.g., Patent Document 1).
However, the deposition method requires high-vacuum facilities and complicated manufacturing processes. In addition, it has been difficult to partition the film(s) into each color section of red, green and blue by using the deposition method. Another problem of the deposition method is that a material-use efficiency is low.

As another method of forming an organic electroluminescence material into films, a coating method has been known.
According to the coating method, which is generally used for forming films from a polymer organic electroluminescent material, an organic electroluminescent material dissolved in a solvent is used for forming thin films of the organic electroluminescent material (for instance, Patent Document 2). Exemplary advantages of the coating method are that thin films can be favorably formed from the organic electroluminescent material in a simplified manner with low cost, and that partition of the film(s) into color sections can be performed in a facilitated manner.
However, synthetic pathway of the polymer organic electroluminescent material is complex, and high purification of the polymer organic electroluminescent material is difficult. Accordingly, no polymer organic electroluminescent material has been known to be excellent in luminous efficiency, lifetime, chromatic purity and the like. Particularly, a blue-emitting polymer organic electroluminescent material is inferior in performance as compared with a blue-emitting low-molecular organic electroluminescent material.

In view of the above, it has been proposed to form films of a low-molecular organic electroluminescent material by coating method.
However, a coating composition with a low-molecular organic electroluminescent material dissolved therein has been problematic in terms of its solubility, viscosity and the like.

In forming thin films of an organic electroluminescent material by coating method, the organic electroluminescent material needs to be dissolved in a solvent.
As for a polymer organic electroluminescent material, a coating composition dissolved in a solvent such as toluene, xylene or tetralin is generally known (e.g., Patent Documents 3, 4, and 5).
However, a low-molecular organic electroluminescent material, which is an insoluble material, is not favorably dissolved in such a solvent as described above in forming films from the low-molecular organic electroluminescent material.

While the coating method is not applicable to materials whose solubility is less than a predetermined value (e.g. 0.5 wt%), a low-molecular organic electroluminescent material generally exhibits solubility of 0.1 wt% to 0.2 wt%. Accordingly, such a low solubility of the low-molecular material has prevented the coating method from being applied to forming films of the low-molecular organic electroluminescent material.
Although the coating method has been recently found applicable to forming films of the low-molecular materials (see, Patent Document 6), the solubility of the low-molecular material according to Patent Document 6 is still insufficient. In addition, when an organic electroluminescence device is actually manufactured using the coating composition disclosed in Patent Document 6, the obtained organic electroluminescence device does not exhibit sufficient performance (luminous efficiency, lifetime, chromatic purity and the like).

Since a coating composition prepared by dissolving a low-molecular organic electroluminescent material in a solvent generally exhibits low solution viscosity, such a composition is less suitable for film forming by coating method.
For instance, when films of an organic electroluminescent material are formed by coating method such as ink printing and nozzle printing, viscosity of 1.5cP or more is required for inkjet method while viscosity of 1cP or more is required for nozzle printing.
A polymer organic electroluminescent material exhibits high viscosity when dissolved in a solvent.

On the other hand, a low-molecular organic electroluminescent material does not exhibit high viscosity by merely dissolving the material in a solvent. For instance, when a low molecular organic electroluminescent material is dissolved in a solvent such as toluene or xylene, viscosity of such a solution is less than 1cP. Accordingly, the viscosity of such a coating composition needs to be enhanced by some suitable means.
A known example of a thickener usable for a coating composition is a viscosity control reagent such as alcohol-based solution. However, when alcohol-based solution, which is a poor solvent for a low-molecular organic electroluminescent material, is added to a low-molecular organic electroluminescent material so as to enhance the viscosity, the mole-molecular organic electroluminescent material exhibits lower solubility.
Another possible method for enhancing the viscosity of a coating composition is to introduce alkyl group(s) having a large number of carbon atoms into a low-molecular organic electroluminescent material. However, even by the above method, the solubility of the low-molecular organic electroluminescent material is lowered.

Patent Document 1: W02004/018587
Patent Document 2: JP-A-2003-229256
Patent Document 3: WO2005/059267
Patent Document 4: JP-A-2002-313561
Patent Document 5: JP-A-2004-119351
Patent Document 6: JP-A-2006-190759

### DISCLOSURE OF THE INVENTION

### PROBLEMS TO BE SOLVED BY THE INVENTION

The above-described problems have prevented application of coating method (i.e., a method capable of forming films in a simplified manner at low cost) to a low-molecular organic electroluminescent material (i.e., a material that is favorably excellent in luminous efficiency, a long lifetime and chromatic purity), thereby awfully hampering a full-scale practical realization of an organic electroluminescent material.

An object of the present invention is to solve the above problem(s) and to provide an organic electroluminescent material-containing solution applicable to forming film(s) of a high-performance organic electroluminescent material by coating method. Another object of the present invention is to provide a method of forming organic electroluminescent thin film(s) using the organic electroluminescent material-containing solution, and an organic electroluminescence device including the organic electroluminescent thin film made by the method.

### MEANS FOR SOLVING THE PROBLEMS

An organic luminescent material-containing solution according to an aspect of the present invention contains an organic electroluminescent material; and a solvent, in which the organic electroluminescent material at least comprises a host and a dopant, the host is an anthracene derivative, and the host is dissolved in the solvent with a content of 0.5 weight percent or more while the solvent exhibits viscosity of 5cP or more.

According to this aspect of the present invention, the organic electroluminescent thin film(s) can be formed by coating method, i.e., a method applicable to forming thin film(s) in a simplified manner at low cost.

The host material and the dopant material will be described below.
An organic electroluminescence device is provided by laminating functional layers such as a hole injecting layer, a hole transporting layer, an emitting layer, an electron transporting layer and an electron injecting layer. The emitting layer contains a host material and a dopant material, where an energy transmission or the like is generated from the host material to the dopant material and light is emitted by the dopant material.
The dopant is added (doped) to the host with an exemplary ratio of the dopant to the host being 0.01 to 20 wt%. Since the host material occupies a major portion (e.g. 80 % or more) of the emitting layer of 30 nm to 100 nm, the host material is required be dissolved in the organic electroluminescent material-containing solution by a predetermined amount for forming a film of the emitting layer by coating method.
According to the aspect of the present invention, since the host that occupies the major portion of the film for the emitting layer exhibits solubility of 0.5 wt% or more, the emitting layer of a sufficient film thickness can be formed by coating method.

In addition, an organic electroluminescent material-containing solution used for coating method is required to contain an organic electroluminescent material by a predetermined amount or more and further to exhibit viscosity of a predetermined degree or more.
For instance, when organic electroluminescent thin film(s) is formed by coating method such as spin coating, inkjet or nozzle printing, the solution is required to exhibit viscosity of several cP or more.
According to the aspect of the present invention, since the viscosity of the solvent is 5cP or more, organic electroluminescent thin films can be formed by coating method. The solution having viscosity of 5cP or more is preferably applicable to inkjet that requires relatively-high viscosity.
The viscosity of the solution is more preferably 6cP or more, further preferably 7cP or more.

Although an upper limit to the viscosity degree will be automatically determined when a need to form thin film(s) of several 10nm thickness using the solution is considered, an exemplary upper limit to the viscosity degree is around 100cP.

The anthracene derivative used as the host exhibits high performance as the organic electroluminescent material. Accordingly, the organic electroluminescent thin film(s) formed by coating method using the organic electroluminescent material-containing solution according to the present invention is excellent in performance such as luminous efficiency, lifetime and chromatic purity.

According to the aspect of the present invention, it is preferable that the solvent contains a biphenyl derivative.
By using a biphenyl derivative as the solvent, the prepared organic electroluminescent material-containing solution can contain a sufficient amount of a low-molecular organic electroluminescent material, and have such high viscosity as to be suitable for coating method.

After various studies, inventors of the present invention have found that a biphenyl derivative exhibits higher viscosity than other solvents, and that a low-molecular organic electroluminescent material can be dissolved in a biphenyl derivative at a high concentration.
The inventors have also found that, by using a biphenyl derivative as the solvent, the prepared organic electroluminescent material-containing solution can contain a sufficient amount of a low-molecular organic electroluminescent material and have such high viscosity as to be suitable for coating method, to reach the invention.

The above Patent Document 2 discloses that an ink composition for an organic electroluminescence device can be prepared by using isopropyl biphenyl (a solvent of high viscosity).
However, the ink composition according to Patent Document 2 is prepared by mainly dissolving a polymer organic electroluminescent material in the solvent.
Although the document describes that a perylene-based or coumarin-based low-molecular organic electroluminescent material is used, such a material is merely used as a small amount of dopant. Patent Document 2 does not disclose that a host made of a low-molecular organic electroluminescent material is dissolved in a solvent at a high concentration.

In addition, when a polymer organic electroluminescent material is used, by merely dissolving the polymer material in a solvent, the prepared solution exhibits high viscosity. Thus, there is no need to consider viscosity of the solution. In contrast, when a low-molecular organic electroluminescent material is used, the prepared solution does not exhibit high viscosity by merely dissolving the material in a solvent.
According to the aspect of the present invention, by selecting a biphenyl derivative of high viscosity, the organic electroluminescent material-containing solution preferably applicable to coating and film forming processes can be prepared even using a low-molecular organic electroluminescent material.

Although a known example of a thickener for organic electroluminescent material-containing solution is alcohol-based solution, a large amount of alcohol-based solution cannot be added to the organic electroluminescent material-containing solution because the solubility of the low-molecular organic electroluminescent material is lowered by the addition of alcohol-based solution ( i.e., a poor solvent for a low-molecular organic electroluminescent material).
Although the viscosity of the organic electroluminescent material-containing solution can also be enhanced by introducing alkyl group(s) having a large number of carbon atoms into the low-molecular organic electroluminescent material, the solubility of the low-molecular organic electroluminescent material is also lowered.
In contrast, according to the present invention, by selecting a biphenyl derivative as the solvent, both the viscosity problem and the solubility problem are solved.

According to the aspect of the present invention, it is preferable that the solvent contains alkyl-substituted biphenyl having an alkyl group as a substituent, the alkyl group having 1 to 10 carbon atoms.
According to such a structure as above, the solubility of the low-molecular organic electroluminescent material in the solvent can be enhanced while the viscosity of the solvent can be enhanced.
Examples of the alkyl-substituted biphenyl are methyl biphenyl, ethyl biphenyl, diethyl biphenyl, isopropyl biphenyl, di-isopropyl biphenyl, n-propyl biphenyl, n-pentyl biphenyl and methoxy biphenyl.
The alkyl group of the alkyl-substituted biphenyl preferably has 1 to 5 carbon atoms, thereby balancing suitable viscosity and suitable solubility.
For instance, ethyl biphenyl, isopropyl biphenyl or the like can be preferably used as the solvent of the organic electroluminescent material-containing solution according to the present invention.

The solvent may be prepared by 100% using a biphenyl derivative or alternatively by mixing a viscosity control reagent or the like therein.
When the solvent is prepared as a mixture solution, 20% or more of the solution may be a biphenyl derivative, 50% or more thereof may be a biphenyl derivative, and 75% or more thereof may be a biphenyl derivative. In order to take advantage of the viscosity of a biphenyl derivative and material solubility in a biphenyl derivative, a biphenyl derivative is preferably contained by a higher content.

According to the aspect of the present invention, it is preferable that the host has a molecular weight of 4000 or less.
It is because such a low-molecular organic electroluminescent material exhibits higher performance as a material for the emitting layer.

According to the aspect of the present invention, it is preferable that the anthracene derivative is represented by a formula (1) as follows,

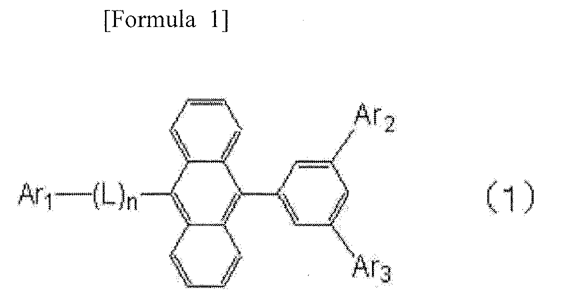

where: Ar₁ to Ar₃ each represent a substituted or unsubstituted aryl group having 5 to 50 atoms forming the ring, a substituted or unsubstituted heteroaryl having 5 to 50 atoms forming the ring, or a fused aromatic group having 10 to 30 carbon atoms; L represents a single bond, a divalent linking group, the divalent linking group being a substituted or unsubstituted arylene group having 5 to 50 atoms forming the ring, or a substituted or unsubstituted heteroarylene group having 5 to 50 atoms forming the ring; and n represents an integer of 1 to 4.

As shown in the formula (1), by attaching a substituent group in meta position to a phenyl group bonded to a central anthracene skeleton, solubility in a solvent can be enhanced. Such material exhibits high performance as the organic electroluminescent material. Accordingly, the organic electroluminescent material-containing solution suitable for film forming by coating method can be obtained.
Although the substituent group is attached at the position 9, 10 of the central anthracene skeleton according to the present invention, the substituent group has been conventionally attached at positions 1 to 4 and 5 to 8 for solubilization. Therefore, the performance as the organic electroluminescent material has been low, whereby luminous performance and lifetime have been insufficient.
In contrast, the compound according to the present invention exhibits high solubility in the solvent and high performance as the organic electroluminescent material.
In addition, since the solubility of the host material can be sufficiently enhanced, the solution may be added with a viscosity control reagent for controlling the viscosity to be suitable for coating method. Although viscosity control reagents are typically a poor solvent, even such a poor solvent (i.e., a viscosity control reagent) can be added to the solution as long as a required amount of the host is securely dissolved therein because the host exhibits sufficiently high solubility.
Accordingly, the organic electroluminescent material-containing solution suitable for the film forming by coating method can be obtained.

In the above formula (1), Ar₁ to Ar₃ each are preferably a substituted or unsubstituted aryl group having 5 to 50 atoms forming the ring, more preferably a substituted or unsubstituted phenyl group or naphthyl group.
By using a phenyl group or a naphthyl group as Ar₁ to Ar₃, both the performance as the host material and the lifetime can be enhanced.

According to the aspect of the present invention, it is preferable that the anthracene derivative is represented by a formula (2) as follows,

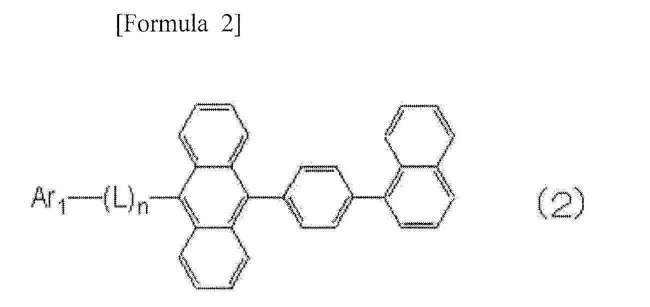

where: Ar₁ represents a substituted or unsubstituted aryl group having 5 to 50 atoms forming the ring or a substituted or unsubstituted heteroaryl having 5 to 50 atoms forming the ring; L represents a divalent linking group, the divalent linking group being a substituted or unsubstituted arylene group having 5 to 50 atoms forming the ring, a substituted or unsubstituted heteroarylene group having 5 to 50 atoms forming the ring, or a fused aromatic group having 10 to 30 carbon atoms; and n represents an integer of 0 to 4.

As shown in the formula (2), by bonding a naphthyl group in para position to the central anthracene skeleton with a phenyl group interposed therebetween, the solubility can also be enhanced.
Since such a compound exhibits high performance as the organic electroluminescent material like the compound of the formula (1), the organic electroluminescent material-containing solution suitable for film forming by coating method can be obtained.
In the above formula (2), Ar₁ is preferably a substituted or unsubstituted aryl group having 5 to 50 atoms forming the ring, more preferably a substituted or unsubstituted phenyl group or naphthyl group.
By using a phenyl group or a naphthyl group as Ar₁, both the performance as the host material and the lifetime can be enhanced.

According to the aspect of the present invention, it is preferable that n in the formula (1) and the formula (2) is an integer in a range of 0 to 2.
While the performance as the organic electroluminescent material cannot be sufficiently exhibited when n is too large, a material excellent in the luminous performance and lifetime can be obtained by setting n to 1 or 2. Since such a material also exhibits a high solubility, the organic electroluminescent material-containing solution suitable for film forming by coating method can be obtained.

According to the aspect of the present invention, it is preferable that a naphthacene derivative represented by a formula (3) as follows is used as the host in place of the anthracene derivative,

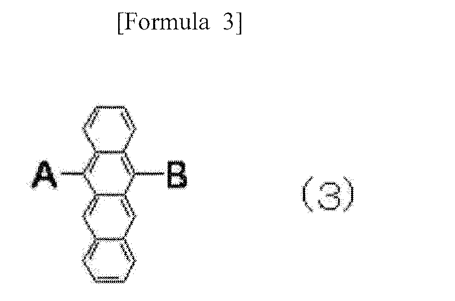

where: A and B each represent a substituted or unsubstituted aromatic group having 6 to 20 carbon atoms or a substituted or unsubstituted fused aromatic group having 10 to 20 carbon atoms, A and B being allowed to be mutually the same or different on a condition that at least either one of A and B has a structure represented by a formula (4) as follows,

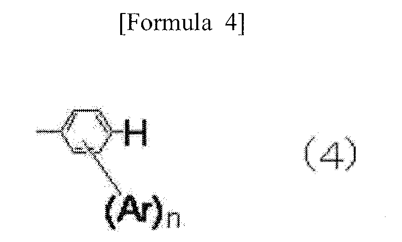

where: Ar represents a substituted or unsubstituted aromatic group having 6 to 20 carbon atoms or a substituted or unsubstituted fused aromatic group having 10 to 20 carbon atoms; and n represents an integer in a range of 0 to 4.

According to such a structure as above, the host exhibits solvent solubility of a predetermined degree or more.
For instance, when an aromatic group as a substituent is bonded to naphthacene skeleton in para position, the solubility is lowered. For example, the following compound exhibits extremely low solubility of 0.1 wt% or less.

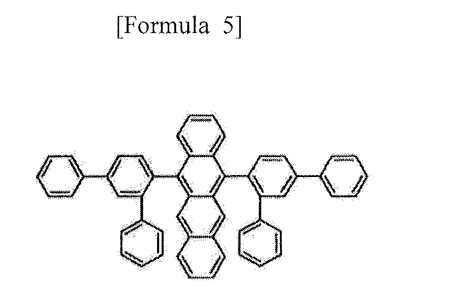

According to the aspect of the present invention, by employing the structure represented by the general formula (4) for the substituent of the naphthacene skeleton, the host can exhibit solvent solubility of a predetermined degree or more. With this arrangement, a compound that exhibits high performance as the organic electroluminescent material and high solubility can be selected, thereby providing an organic electroluminescent material-containing solution preferably applicable to coating method.

When n is 0, the formula (4) represents an unsubstituted phenyl group. While it is important that the compound represented by the formula (3) does not contain two substituents in para positions, n may be 0. It is preferable that n in the formula (4) is preferably an integer in a range of 0 to 2.

According to the aspect of the present invention, it is preferable that the dopant is a styrylamine derivative represented by a formula (5) as follows,

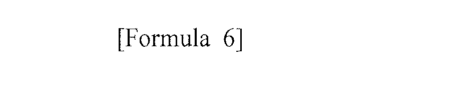

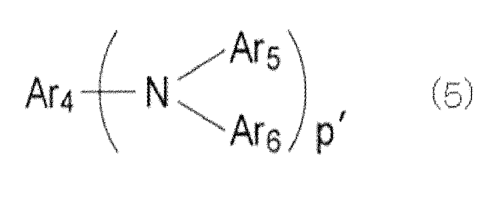

where: at least one of Ar₄ to Ar₆ has a substituted or unsubstituted styryl group.
Preferably, Ar₄ is selected from a group consisting of a phenyl group, a biphenyl group, a terphenyl group, a stilbene group and a distyryl-aryl group while Ar₅ and Ar₆ each are either one of a hydrogen atom and an aromatic group having 6 to 20 carbon atoms. P' is an integer of 1 to 4.

The aromatic group having 6 to 20 carbon atoms is preferably a phenyl group, a naphthyl group, an anthracenyl group, a phenanthryl group, a terphenyl group or the like.

According to the aspect of the present invention, it is preferable that a substituted derivative of arylamine represented by a formula (6) as follows is used as the dopant in place of the styrylamine derivative represented by the formula (5),

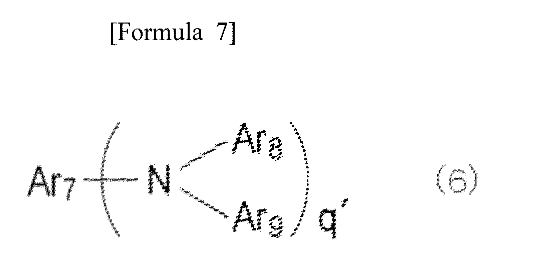

where: Ar₇ to Ar₉ each represent a substituted or unsubstituted aryl group having 5 to 40 carbon atoms forming the aromatic ring; and q' represents an integer in a range of 1 to 4.

In the formula above, the aryl group having 5 to 40 atoms forming the ring is preferably a phenyl group, a naphthyl group, an anthracenyl group, a phenanthryl group, a pyrenyl group, a chrysenyl group, a coronyl group, a biphenyl group, a terphenyl group, a pyrrolyl group, a furanyl group, a thiophenyl group, a benzothiophenyl group, an oxadiazolyl group, a diphenyl anthracenyl group, an indolyl group, a carbazolyl group, a pyridyl group, a benzoquinolyl group, a fluorenyl group, a fluoranthenyl group, an acenaphthofluoranthenyl group, a stilbene group, a group represented by a general formula (A) or (B) below or the like.
In the general formula (A) below, r is an integer in a range of 1 to 3.

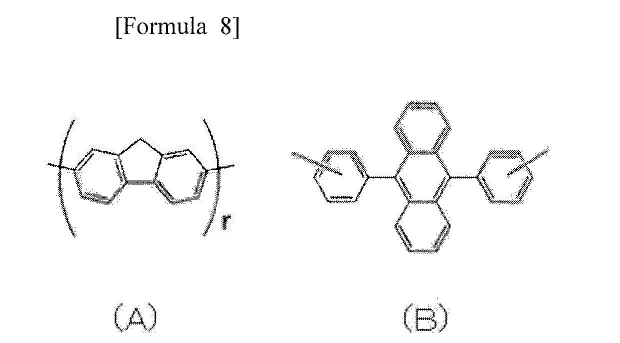

The aryl group having 5 to 40 atoms forming the ring may be further substituted by a substituent group. A preferable example of the substituent group is an alkyl group having 2 to 6 carbon atoms (e.g., an ethyl group, a methyl group, an isopropyl group, an n-propyl group, an s-butyl group, a t-butyl group, a pentyl group, a hexyl group, a cyclopentyl group and a cyclohexyl group).

According to the aspect of the present invention, it is preferable that the dopant is an indenoperylene derivative represented by a formula (7) as follows,

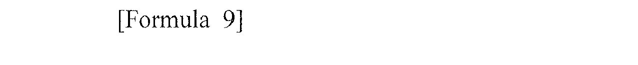

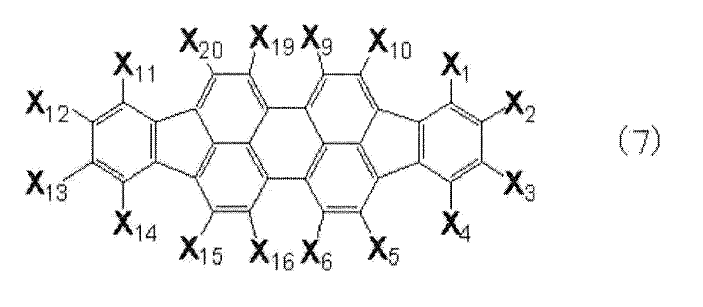

where: X₁ to X₆, X₉, X₁₀, X₁₁ to X₁₆, X₁₉ and X₂₀ each represent a hydrogen atom, a halogen atom, an alkyl group, an alkoxy group, an alkylthio group, an alkenyl group, an alkenyloxy group, an alkenylthio group, an aromatic ring-containing alkyl group, an aromatic ring-containing alkyloxy group, an aromatic ring-containing alkylthio group, an aromatic ring group, an aromatic heterocyclic group, an aromatic-ring oxy group, an aromatic-ring thio group, an aromatic-ring alkenyl group, an alkenyl aromatic ring group, an amino group, a carbazolyl group, a cyano group, a hydroxyl group, -COOR^{1'} (R^{1'} represents a hydrogen atom, an alkyl group, an alkenyl group, an aromatic ring-containing alkyl group or an aromatic ring group), -COR^{2'} (R^{2'} represents a hydrogen atom, an alkyl group, an alkenyl group, an aromatic ring-containing alkyl group, an aromatic ring group or an amino group) or -OCOR^{3'} (R^{3'} represents an alkyl group, an alkenyl group, an aromatic ring-containing alkyl group or an aromatic ring group); an adjacent set of X₁ to X₆, X₉, X₁₀, X₁₁ to X₁₆, X₁₉ and X₂₀ is allowed to be mutually bonded to form a cyclic structure or is allowed to form a cyclic structure together with substituting carbon atoms; and at least one of X₁ to X₆, X₉, X₁₀, X₁₁ to X₁₆, X₁₉ and X₂₀ is not a hydrogen atom.

According to the aspect of the present invention, it is preferable that the indenoperylene derivative is represented by a formula (8) as follows,

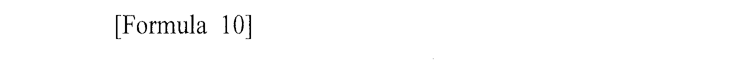

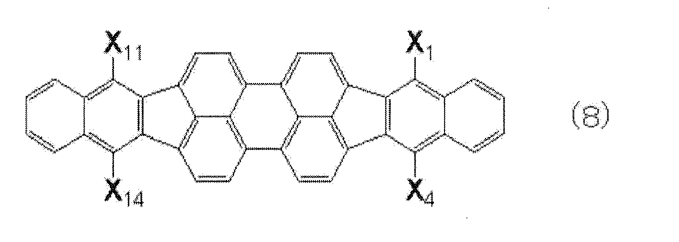

where X₁, X₄, X₁₁, X₁₄ each represent an aromatic ring group.
The aromatic ring group is preferably a phenyl group, an ortho biphenyl group, a meta biphenyl group or a naphthyl group, more preferably a phenyl group or an ortho biphenyl group.

According to the aspect of the present invention, the organic electroluminescent material-containing solution preferably contains a viscosity control reagent.
With this arrangement, the viscosity of the organic electroluminescent material-containing solution can be controlled, thereby more reliably providing a solution having viscosity suitable for film forming by coating method.
Control of the viscosity means not only enhancing the viscosity but also lowering viscosity.

A method of forming organic electroluminescent thin film(s) according to another aspect of the present invention includes forming film(s) of the organic electroluminescent material using the above-described organic electroluminescent material-containing solution.
According to the aspect of the present invention, it is preferable that the method includes: ejecting the organic electroluminescent material-containing solution by inkjet method; and forming film(s) of the organic electroluminescent material by volatilizing the solvent from the ejected organic electroluminescent material-containing solution.
With this arrangement, a low-molecular organic electroluminescent material highly excellent in luminous efficiency, lifetime, chromatic purity and the like can be formed into films by coating method, i.e., a method applicable to film forming in a simplified manner with low cost.

As the method of forming organic electroluminescent thin films through coating processes, not only the above-described inkjet method but also coating method such as spin coating, casting, micro-gravure coating, gravure coating, bar coating, roll coating, wire-bar coating, dip-coating, spray coating, screen printing, flexo printing and offset printing may be used. Such a printing method as screen printing, flexo printing, offset printing and ink-jet printing is preferable in that it is easy to perform pattern forming and multi-color coating.

An organic electroluminescence device according to still further aspect of the present invention includes organic electroluminescent thin film(s) formed by the above described method of forming organic electroluminescent thin film(s).

### BEST MODE FOR CARRYING OUT THE INVENTION

Embodiments according to the present invention will be described.

An organic electroluminescent material-containing solution according to an aspect of the present invention is prepared by dissolving an organic electroluminescent material in a solvent.
The organic electroluminescent material-containing solution contains a host and a dopant.
The host preferably has a molecular weight of 4000 or less. Further, the host is preferably an anthracene derivative.

The anthracene derivative may be a compound represented by the above formula (1) or the above formula (2) as follows.
Examples of such an anthracene derivative are as follows.

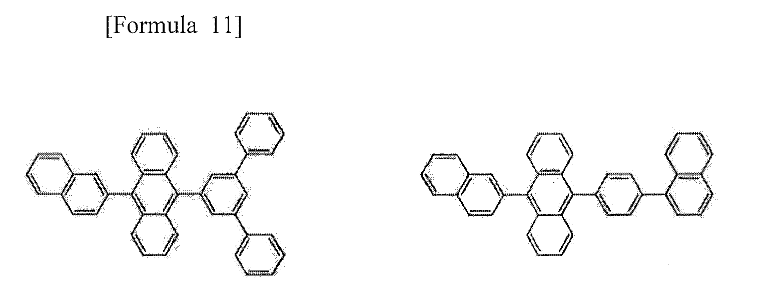

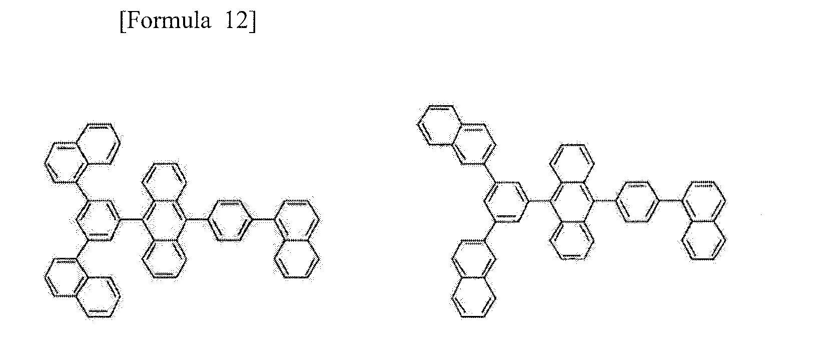

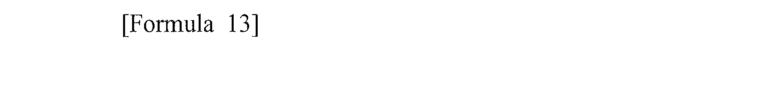

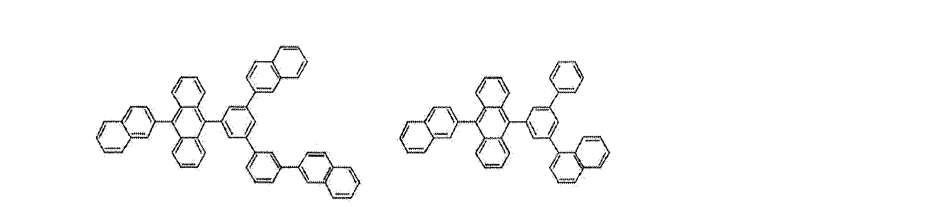

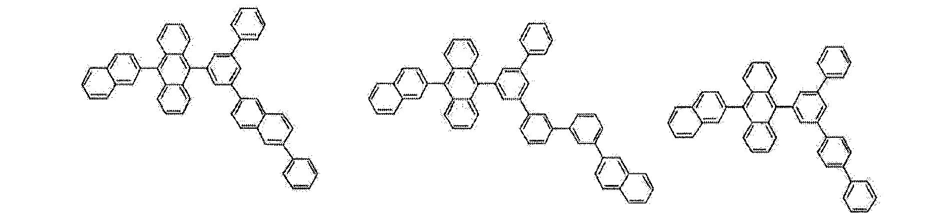

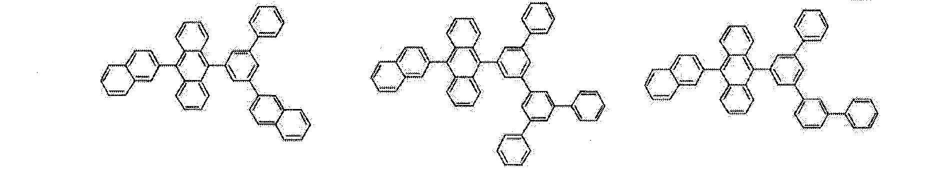

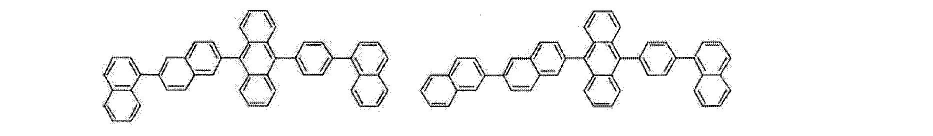

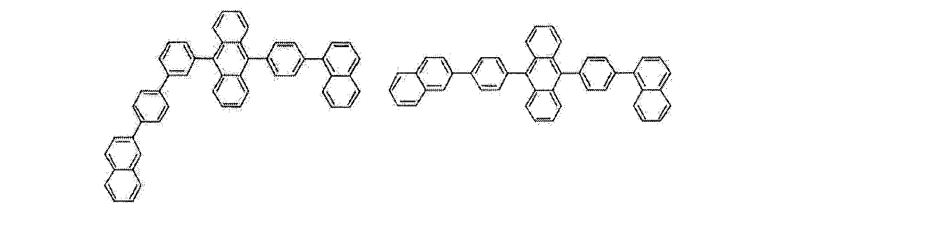

In place of the anthracene derivative, a naphthacene derivative represented by the above formula (3) may be used as the host.
Examples of the naphthacene derivative are compounds as follows.

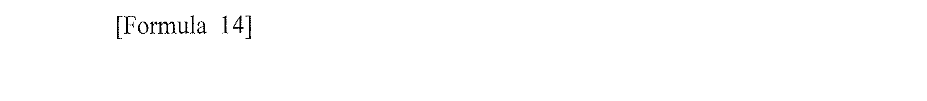

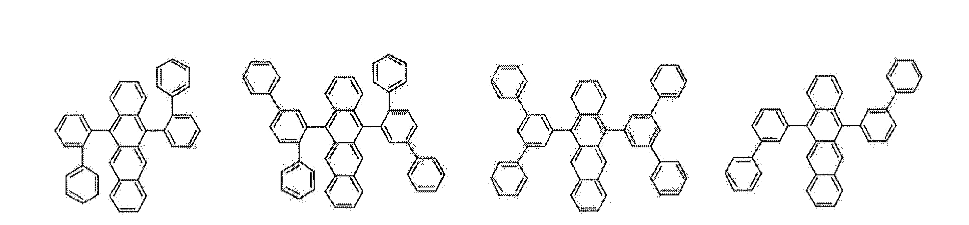

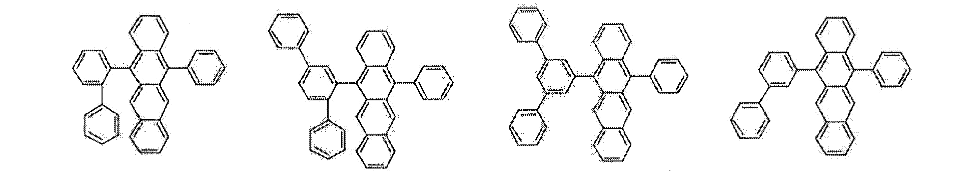

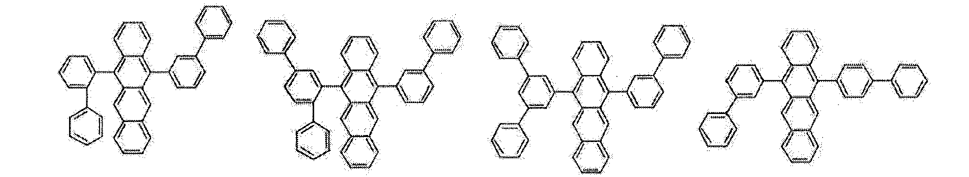

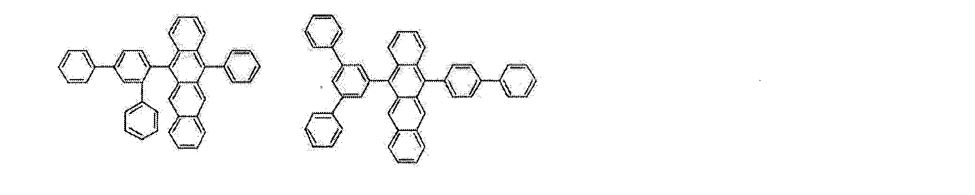

Examples of a dopant used together with the host containing the above anthracene derivative are a styrylamine derivative represented by the above formula (5) and a substituted derivative of arylamine represented by the above formula (6).
Examples of the dopant are compounds shown below.

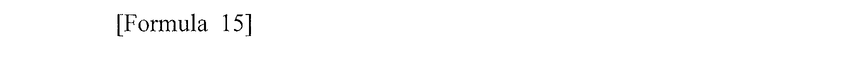

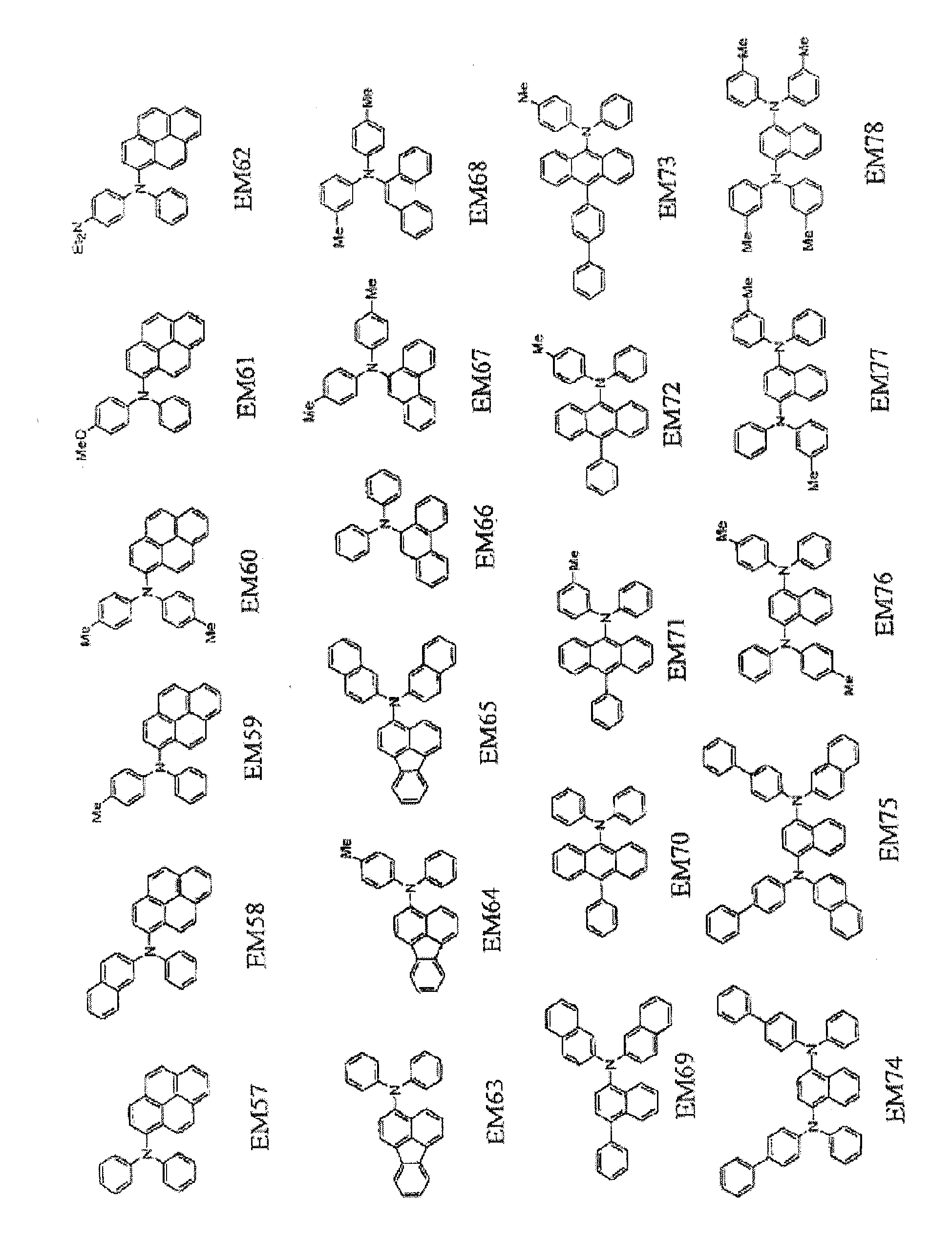

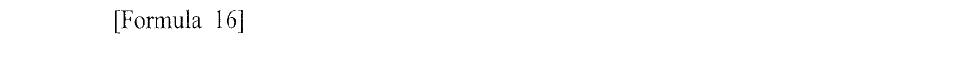

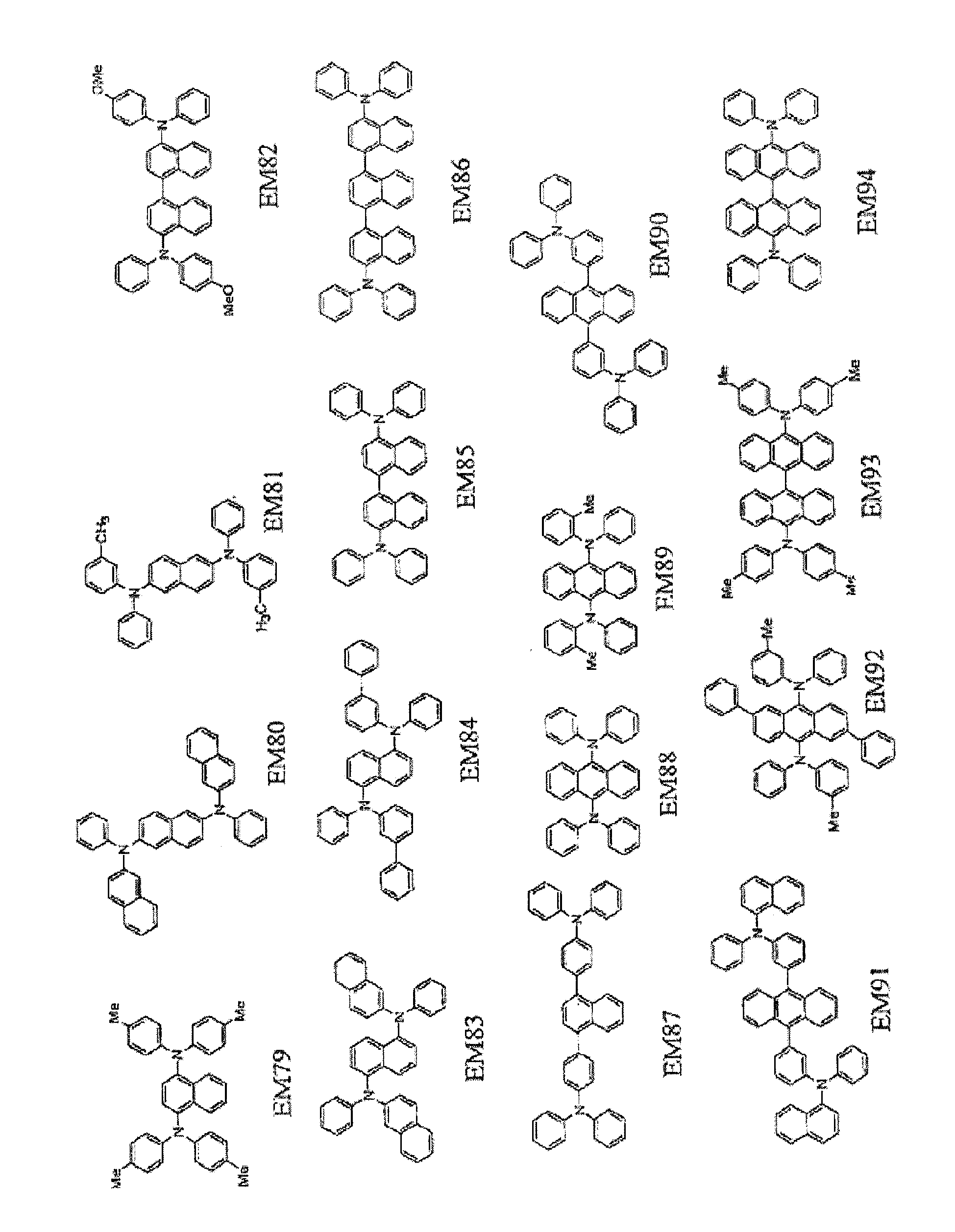

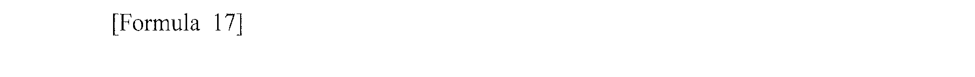

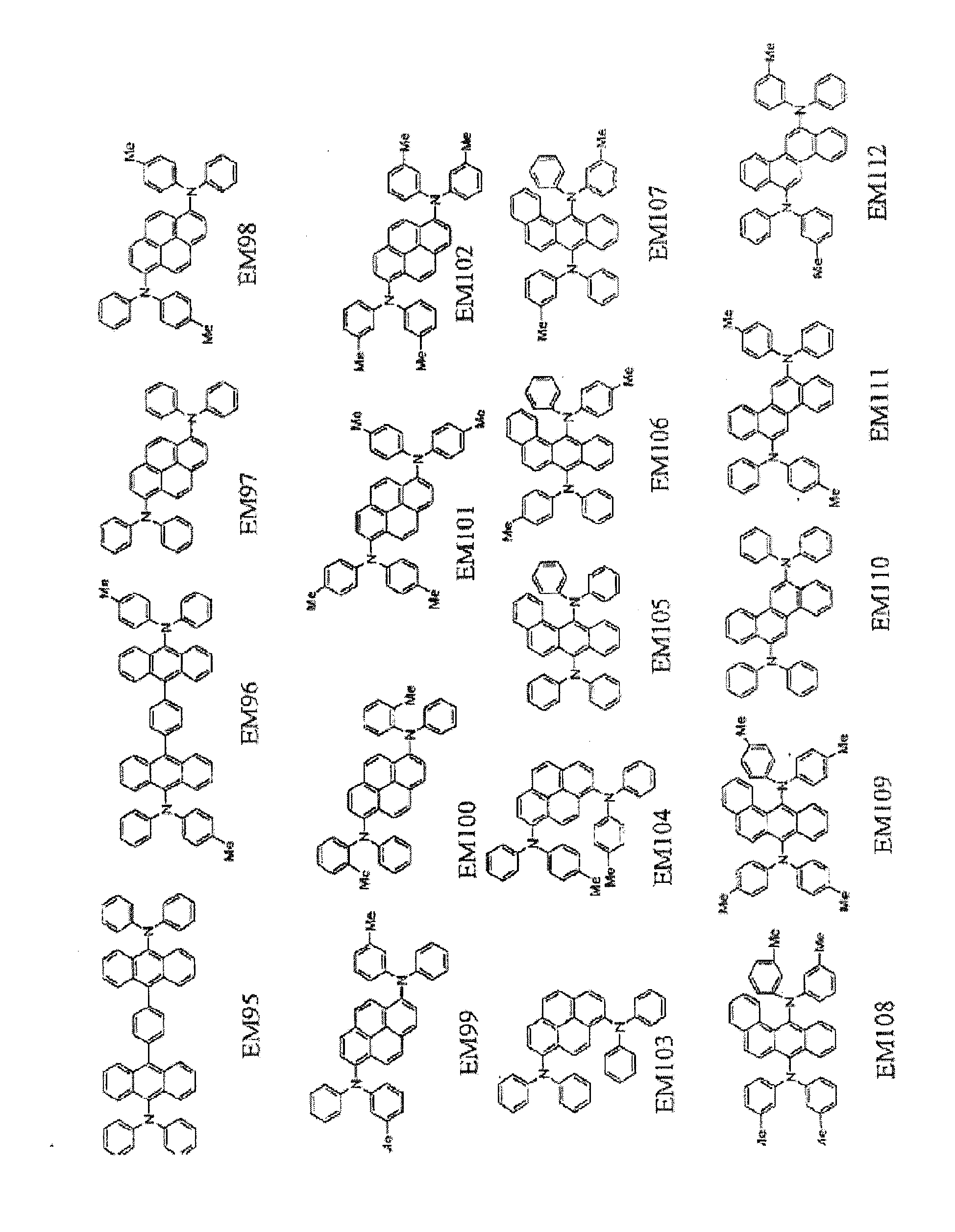

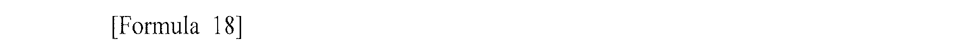

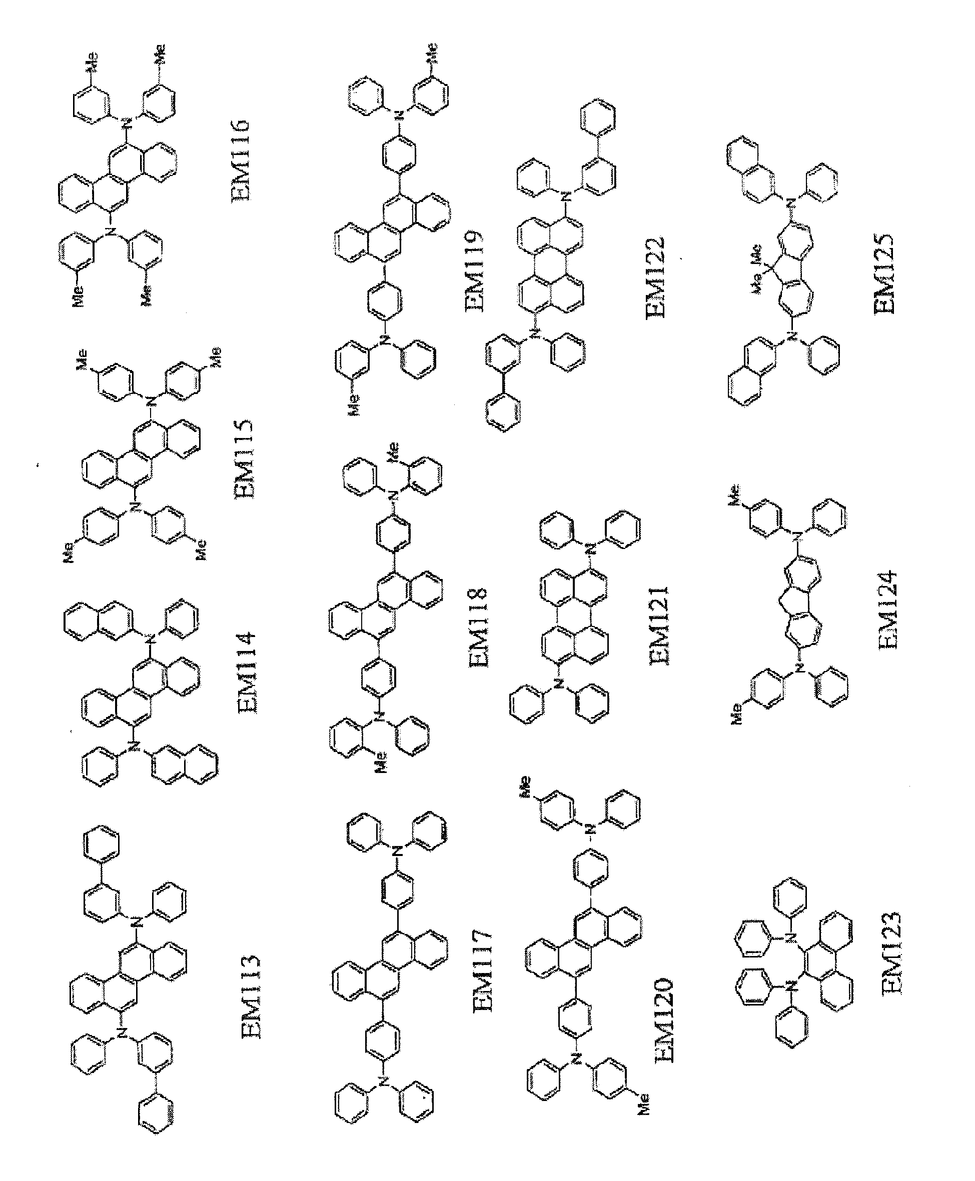

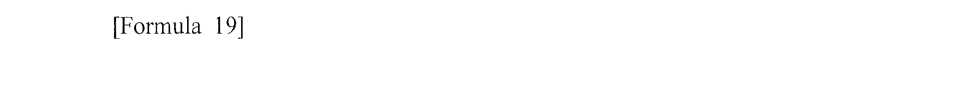

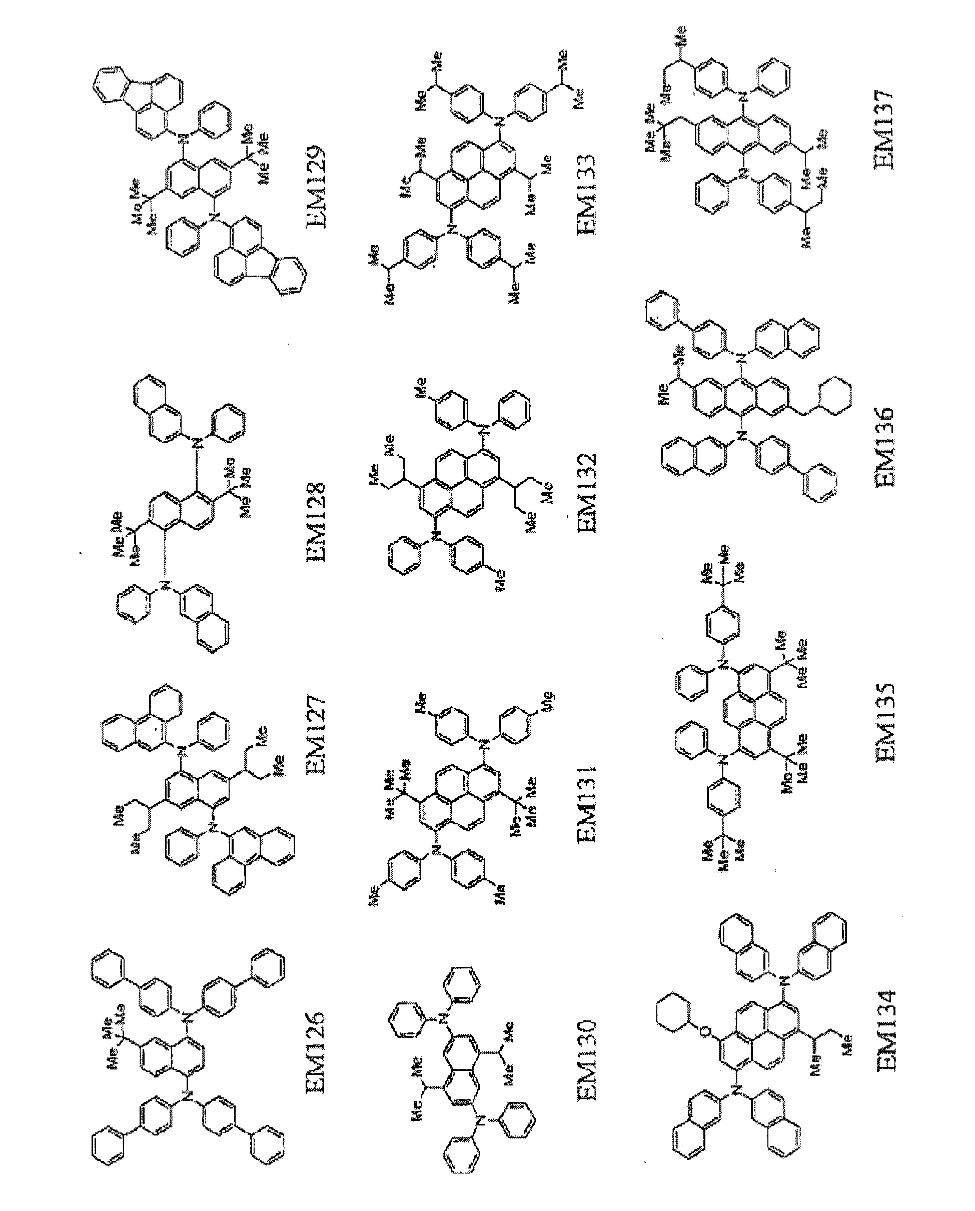

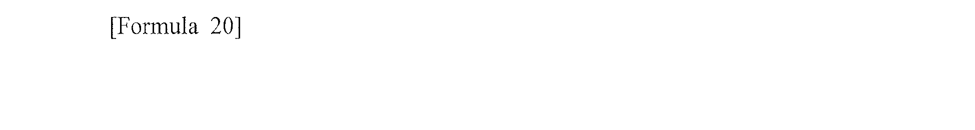

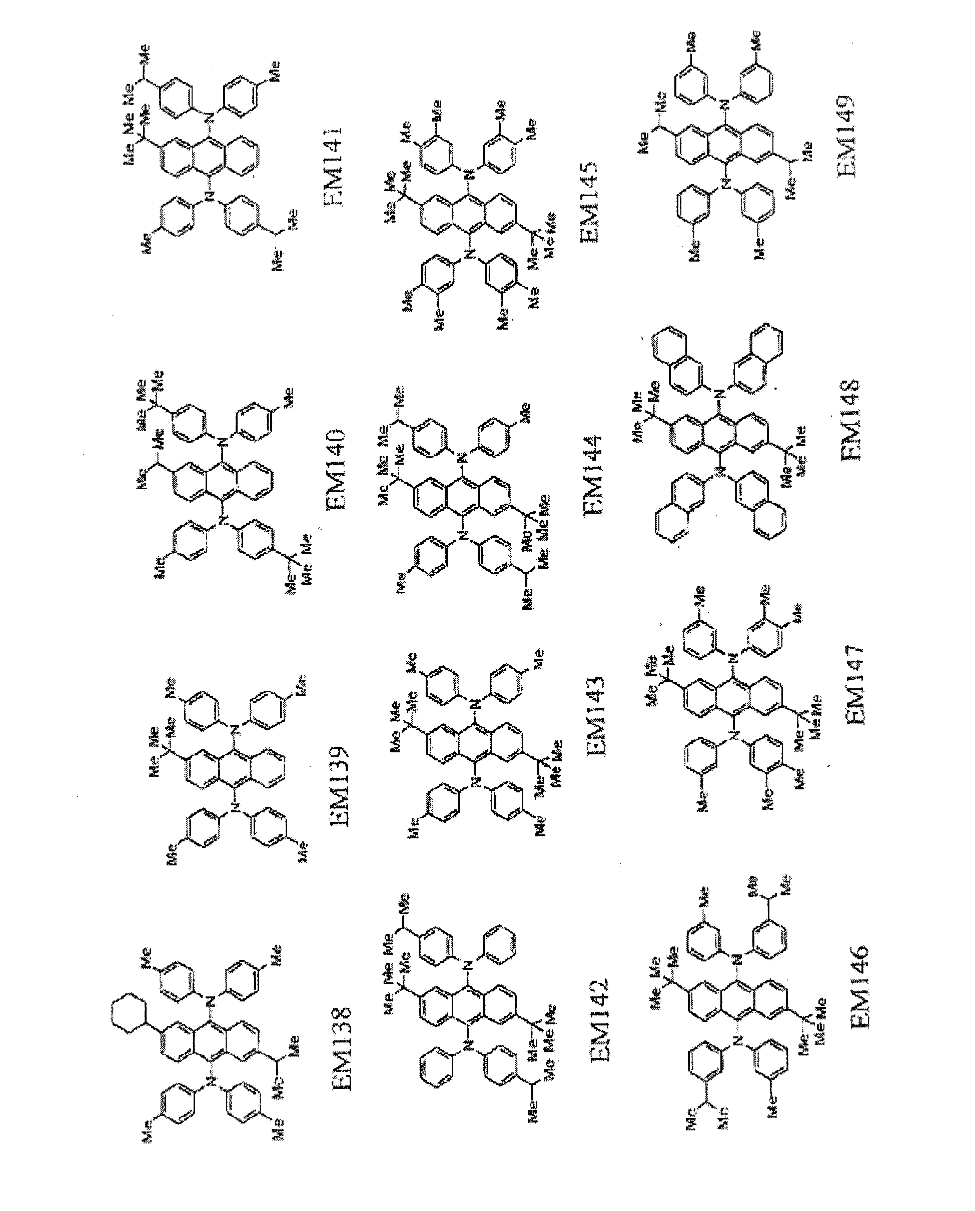

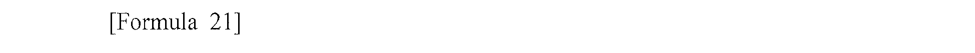

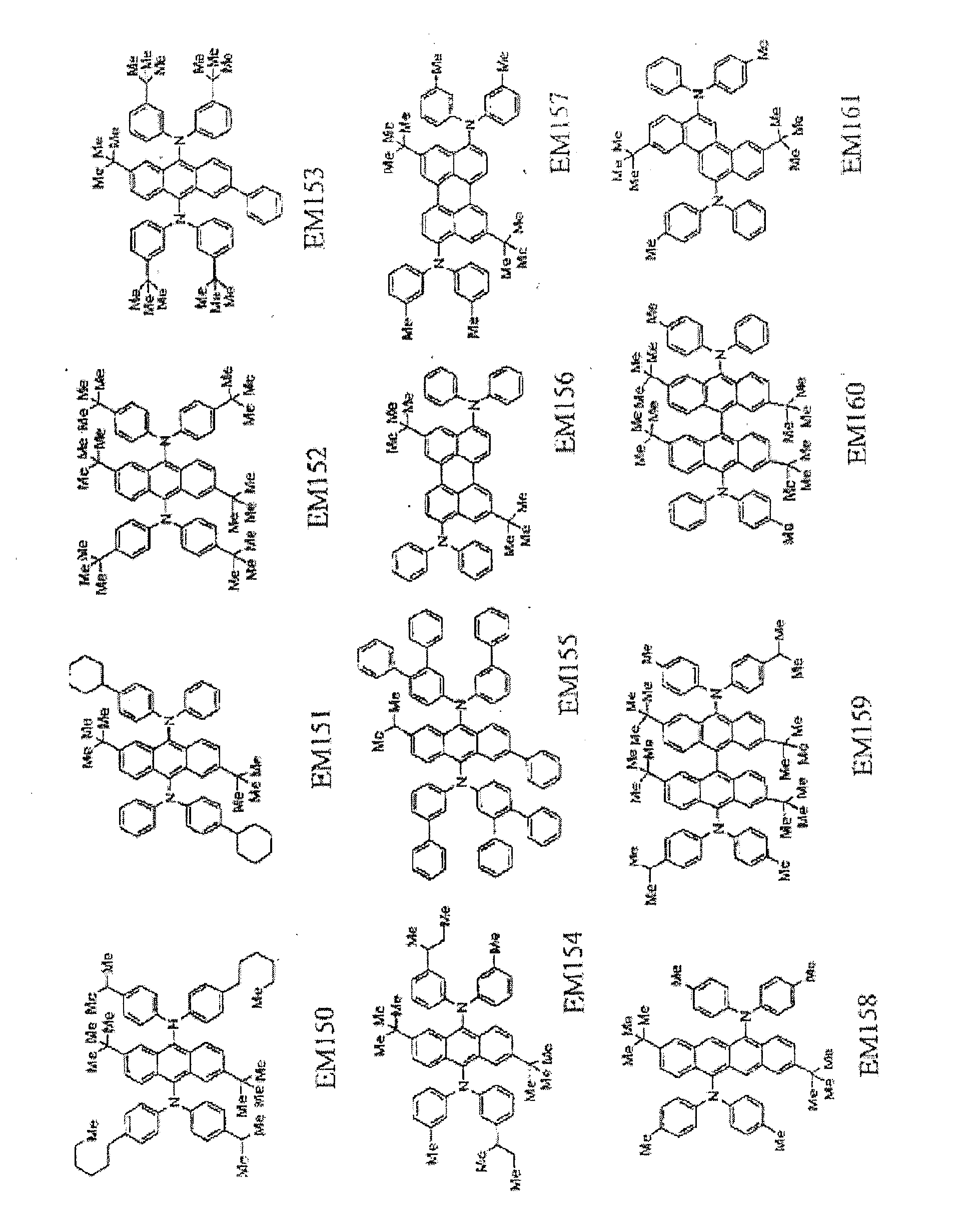

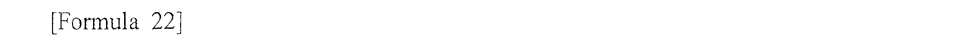

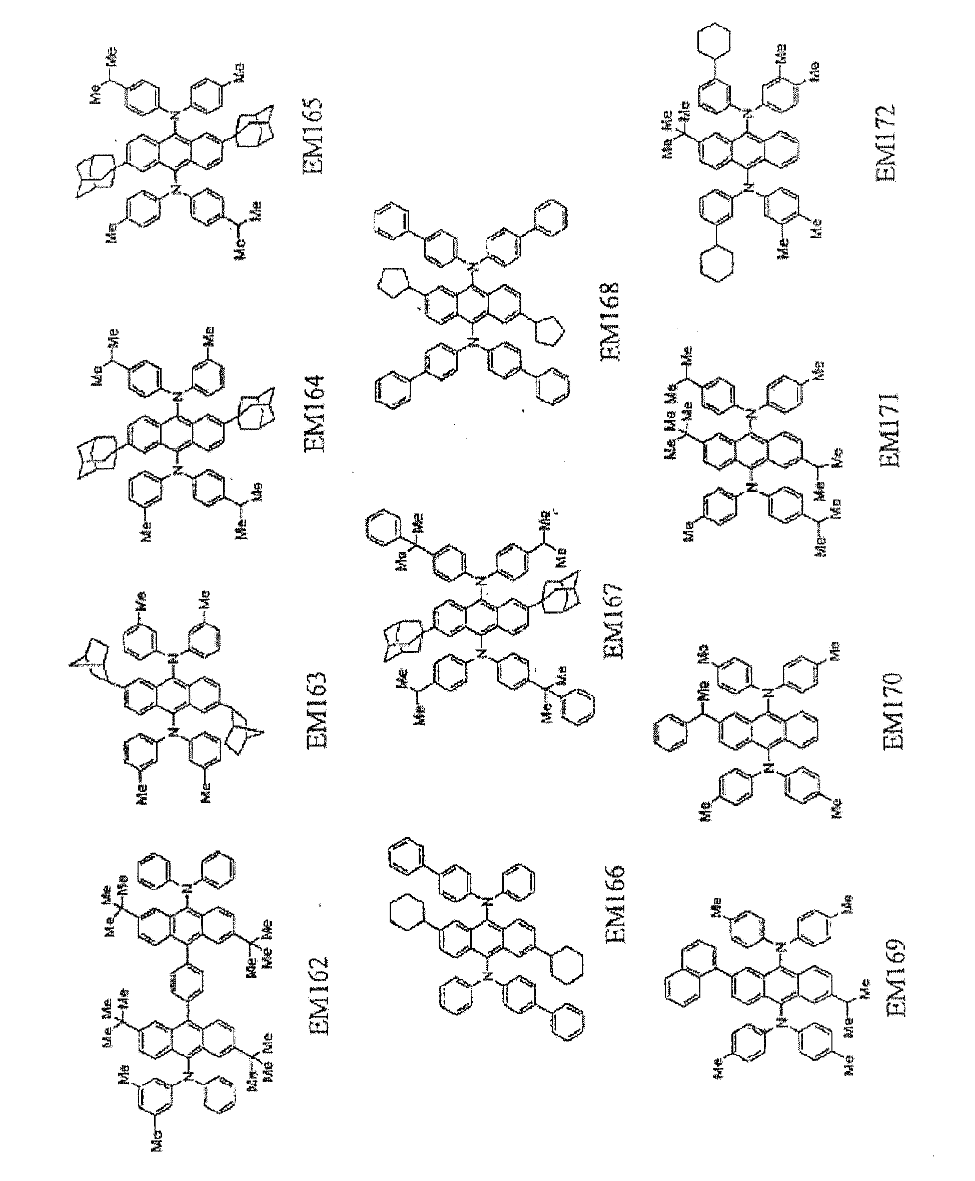

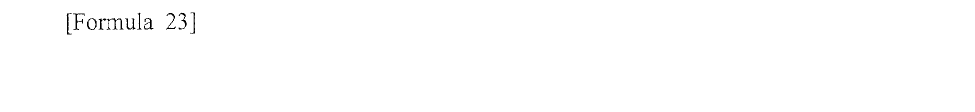

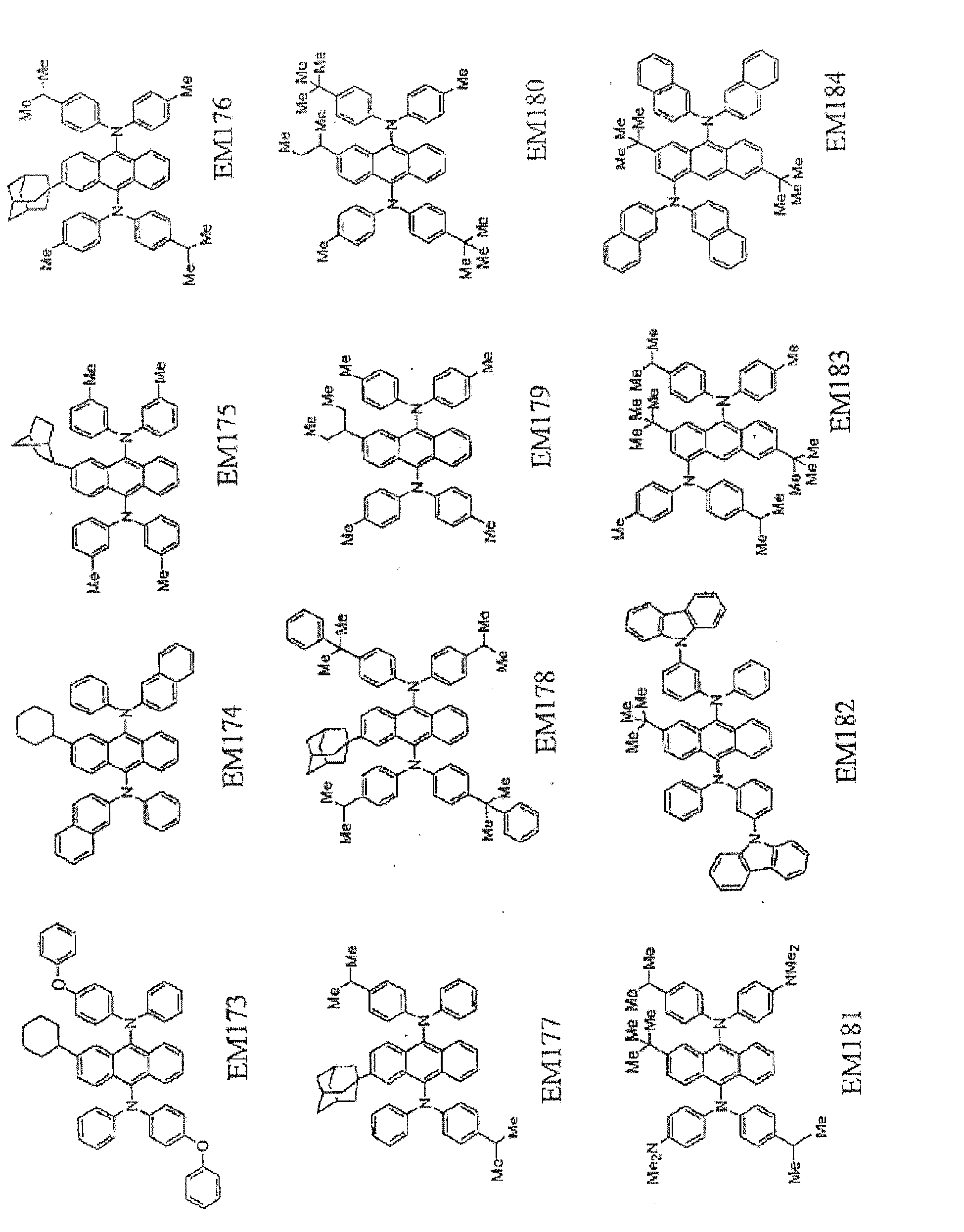

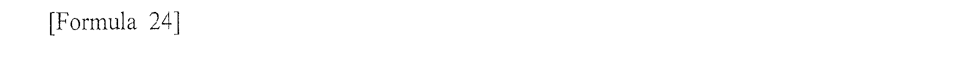

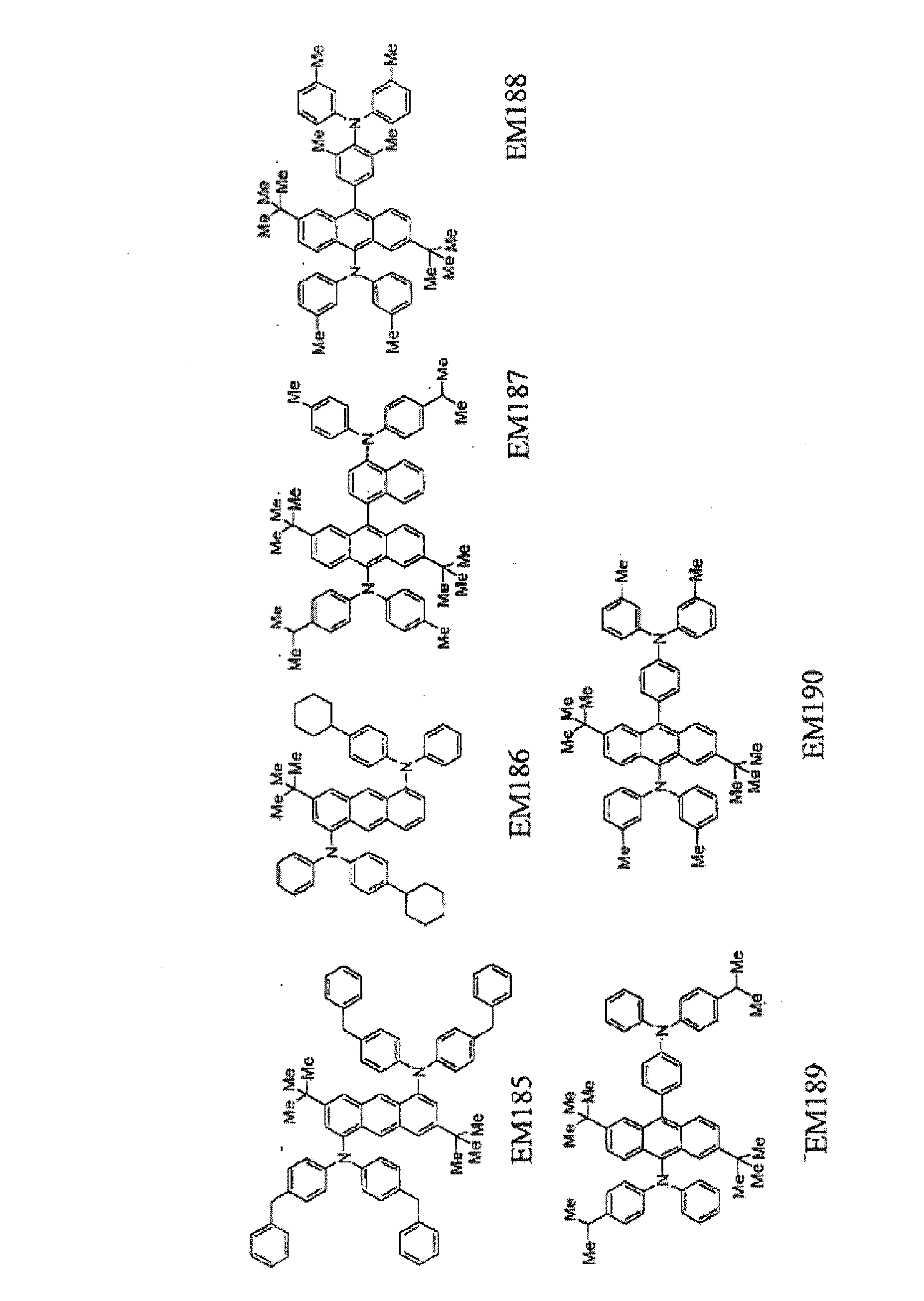

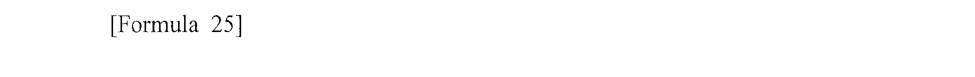

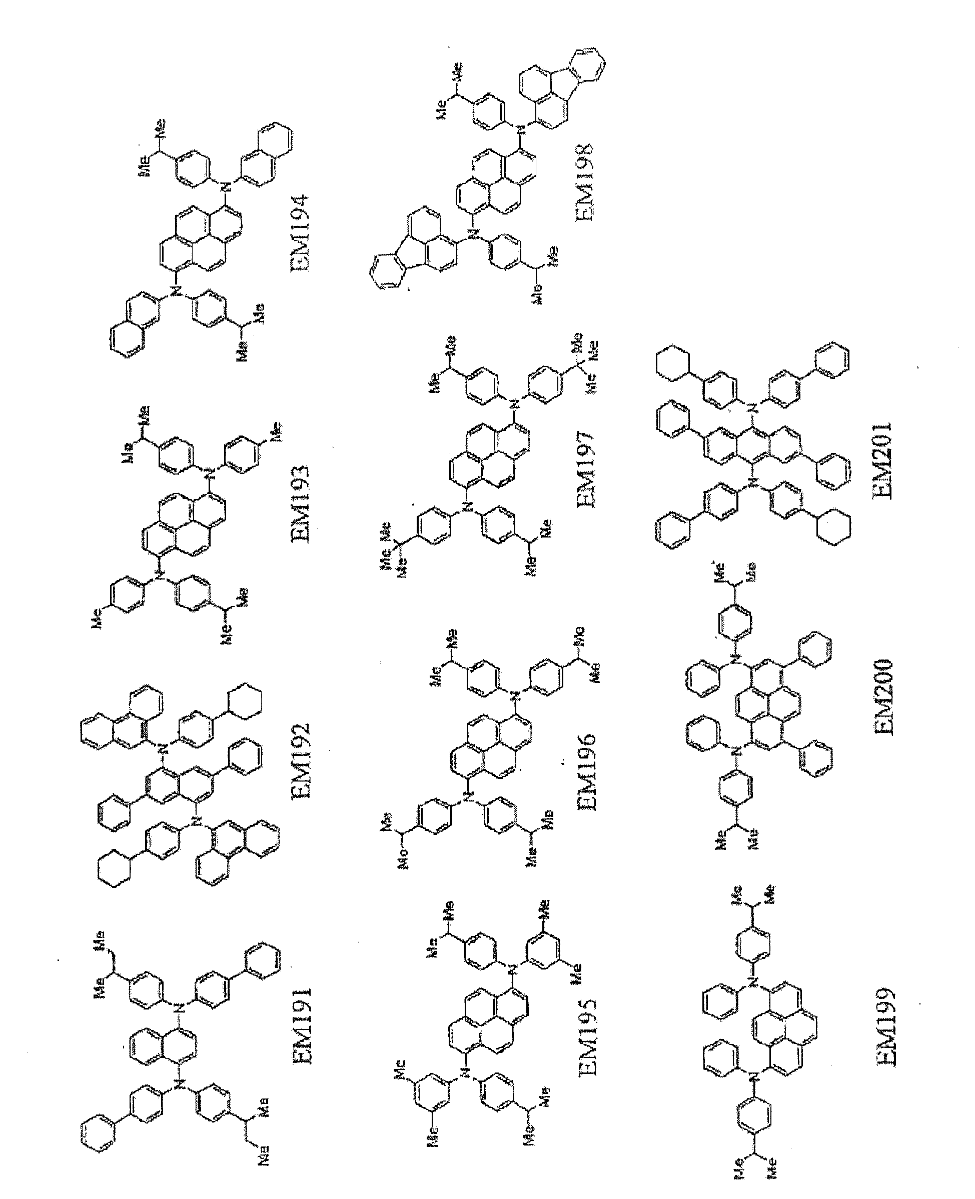

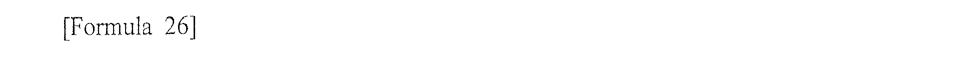

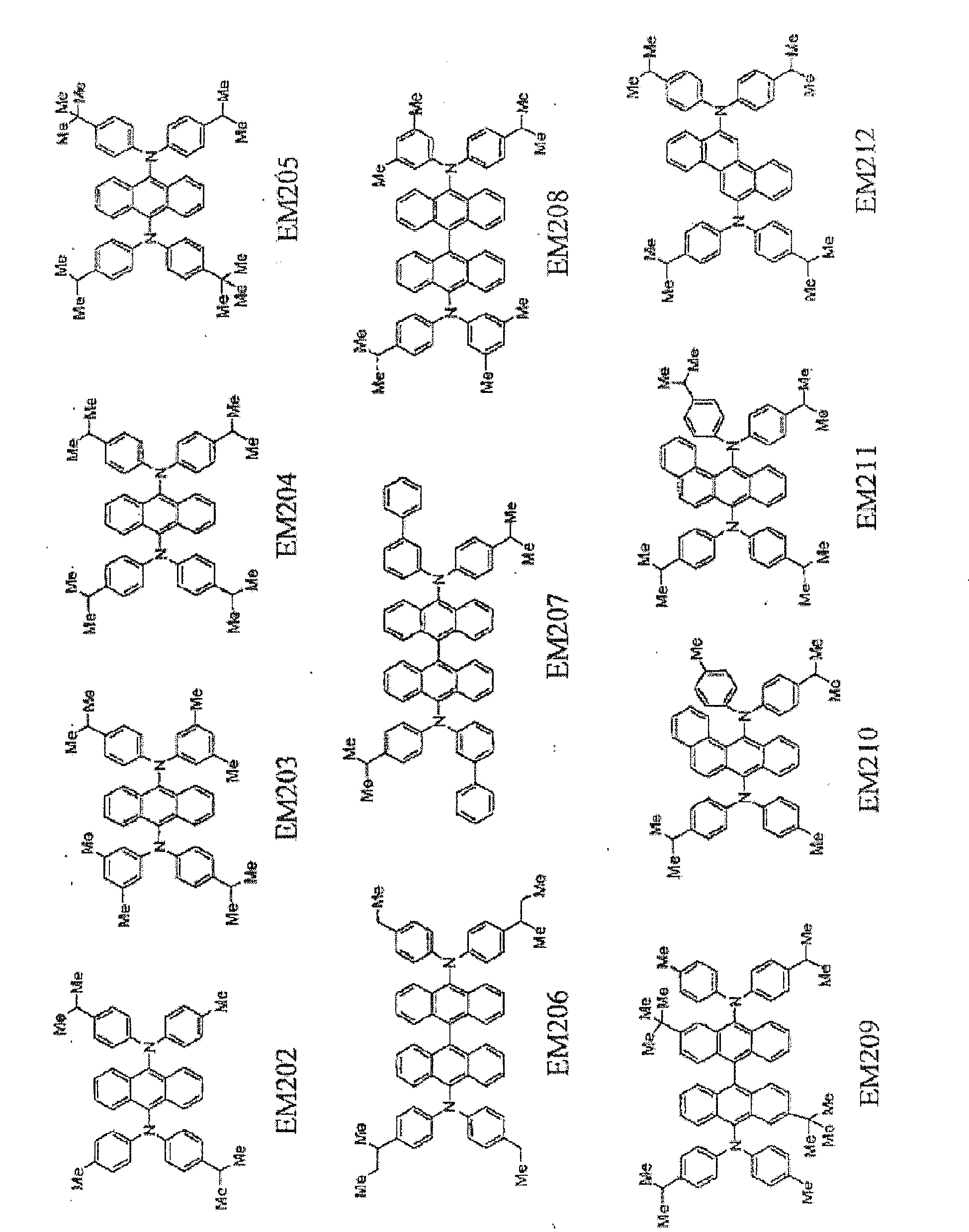

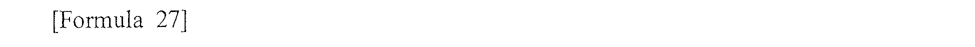

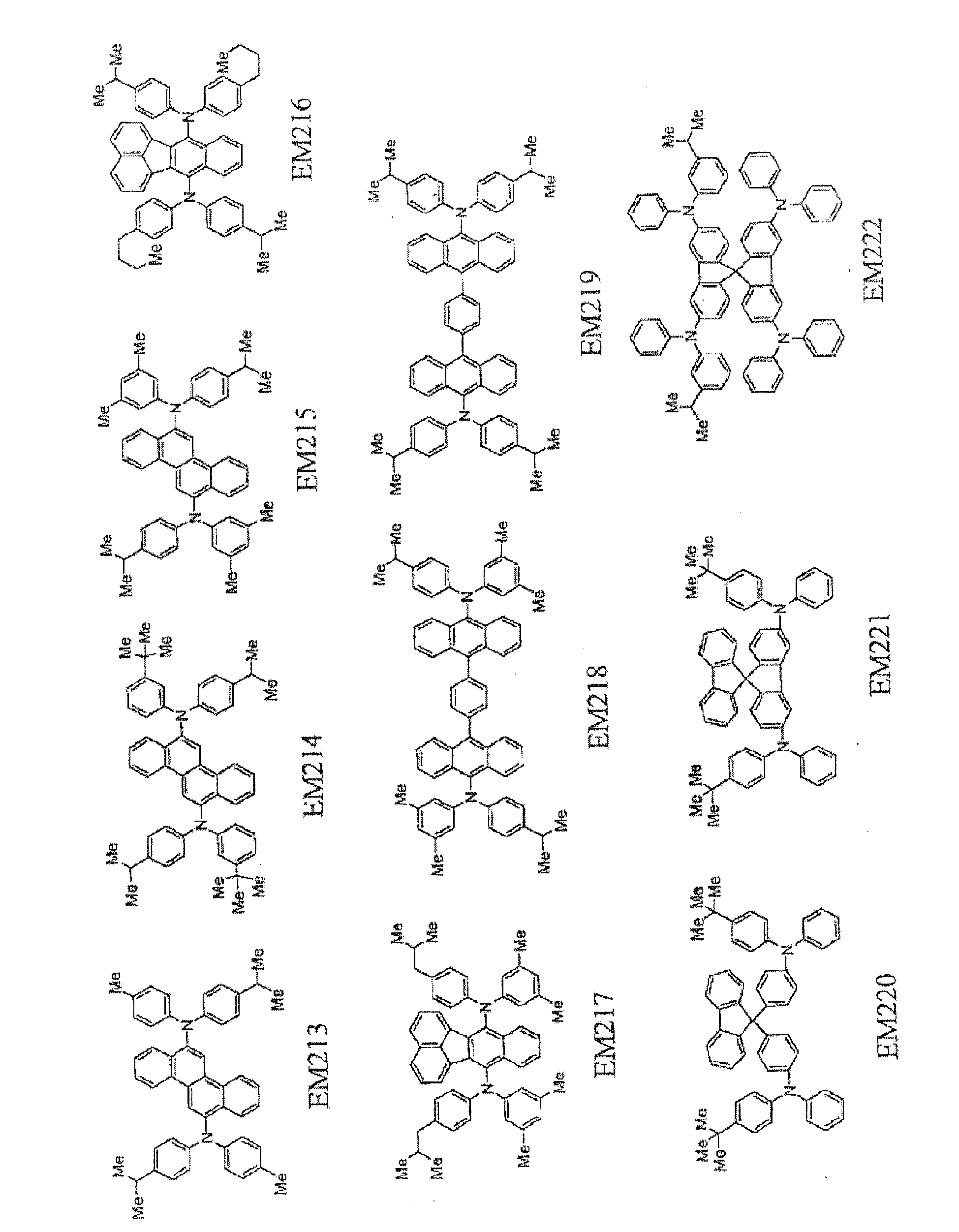

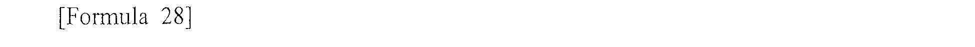

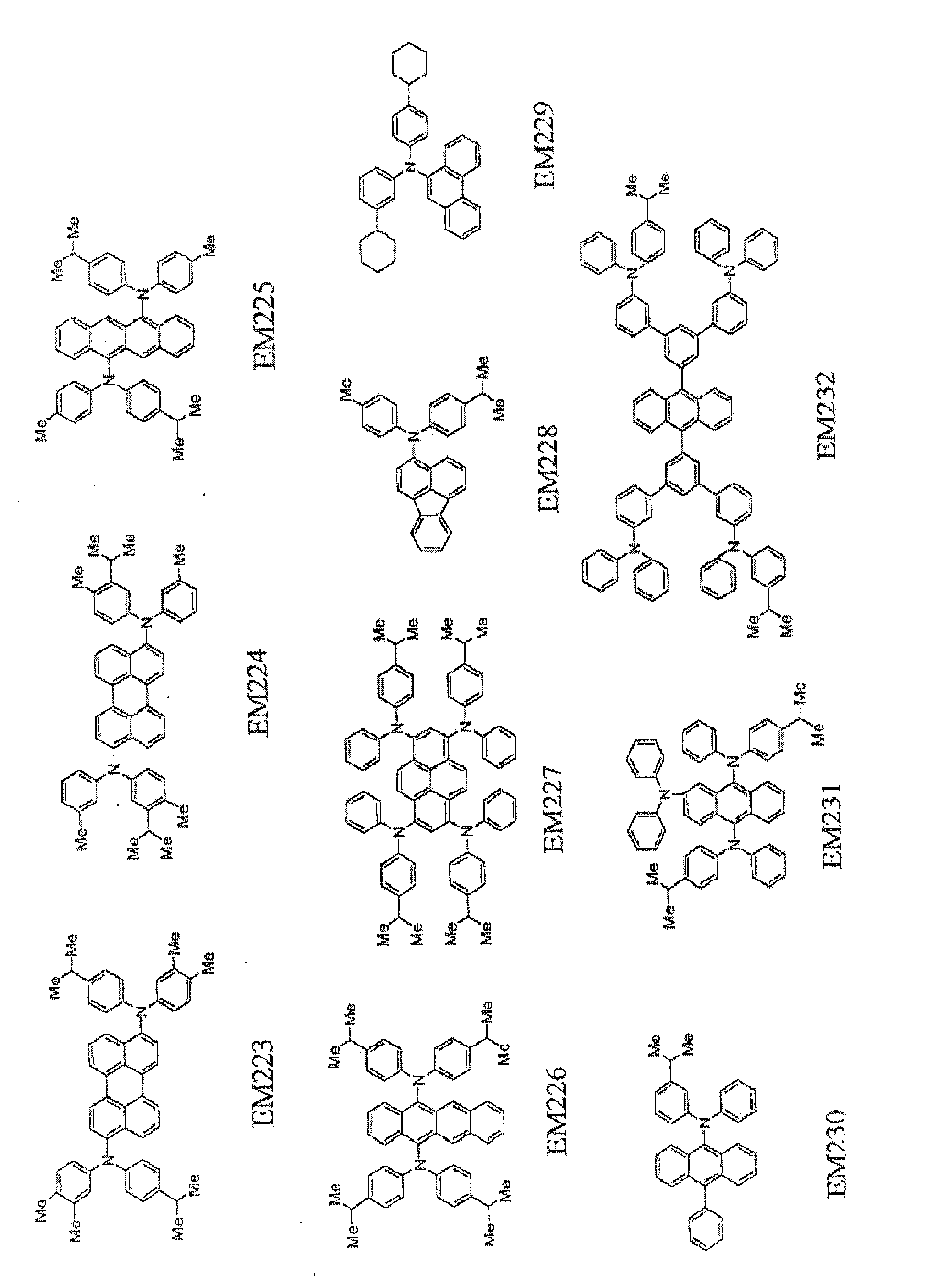

An example of the dopant used together with the host containing the above naphthacene derivative (represented by the formula (3)) is an indenoperylene derivative represented by the above formula (7) or preferably an indenoperylene derivative represented by the above formula (8).

0.5 wt% or more of the host is dissolved in the solvent while the viscosity of the solvent is 5cP or more.
The solvent preferably contains a biphenyl derivative. The solvent more preferably contains an alkyl-substituted biphenyl that includes an alkyl group having 1 to 10 carbon atoms as the substituent.
Examples of the alkyl-substituted biphenyl are methyl biphenyl, ethyl biphenyl, diethyl biphenyl, isopropyl biphenyl, di-isopropyl biphenyl, n-propyl biphenyl, n-pentyl biphenyl and methoxy biphenyl.
The alkyl group of the alkyl-substituted biphenyl more preferably has 1 to 5 carbon atoms. For instance, ethyl biphenyl, isopropyl biphenyl or the like can be preferably used as the solvent.

The organic electroluminescent material-containing solution preferably contains a viscosity control reagent.
Examples of the viscosity control reagent are alcohol-based solution, ketone-based solution, paraffin-based solution and alkyl-substituted aromatic solution.
The viscosity control reagent is preferably alcohol-based solution or alkyl-substituted aromatic solution.

Examples of alcohol-based solution are methanol, ethanol, propanol, n-butanol, s-butanol, 2-methyl-1-butanol, 2-methyl-2-butanol, 3-methyl-2-butanol, t-butanol, n-pentanol, 4-methyl-2-pentanol, 3-methyl-1-pentine-3-ol, n-hexanol, 2-ethylhexanol, 3,5-dimethyl-1-hexine-3-ol, n-heptanol, 3,3,5-trimethyl-hexanol, 3-heptanol, n-octanol, 2-octanol, n-nonanol, n-decanol, methylcyclohexanol, cyclohexanol, α-terpineol, neopentyl alcohol, glycidol, methyl cellosolve, ethylene glycol, propanediol, butanediol and benzyl alcohol. The above alcohols may be of a linear structure or of a branched structure.

Examples of the alkyl-substituted aromatic solution are linear or branched butyl benzene, dodecyl benzene, tetralin, cyclohexyl benzene, dicyclohexyl benzene, 1,1-bis(3,4-dimethylphenyl)ethane and 3-methyl diphenyl ether. Among the above viscosity control reagents, reagents having viscosity of more than 5cP and reagents having viscosity of more than 10cP are preferable.
As the viscosity control reagent, one of the above examples may be singularly used, or a mixture of plurality thereof may be used.

### [Example]

Example(s) and Comparative(s) of the present invention will be described below.

### (Examples 1 and 2, Comparatives 1 to 9)

100mg of a compound A represented by the following formula was put into a sample bottle, and a solvent was dropped thereinto while stirring until the compound A was completely dissolved. The solubility of the compound A in the solvent was calculated from an amount of the dropped solvent. The viscosity of the solvent was measured at the temperature of 22 degrees C. The results are shown in Table 1.

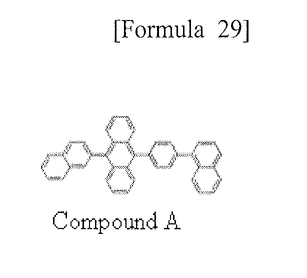

**[Table 1]**

| | Solvent | Viscosity (cP) | Solubility (wt%) |
|---|---|---|---|
| Example 1 | 3-ethylbiphenyl | 5.6 | 2 |
| Example 2 | 4-isopropylbiphenyl | 6.9 | 1 |
| Comparative 1 | toluene | 0.65 | 5 |
| Comparative 2 | xylene | 0.76 | 2 |
| Comparative 3 | mesitylene | 0.76 | 2 |
| Comparative 4 | cyclohexyl benzene | 2.6 | <0.5 |
| Comparative 5 | s-butylbenzene | 1.0 | 1 |
| Comparative 6 | t-butylbenzene | 1.2 | 1 |
| Comparative 7 | dodecylbenzene | 4.5 | <0.5 |
| Comparative 8 | tetralin | 2.3 | <0.5 |
| Comparative 9 | 1,1-bis(3,4-dimethylphenyl)methane | 33.6 | <0.5 |

In order to form the emitting layer of a sufficient film thickness, several wt% or more of the host is preferably dissolved in the organic electroluminescent material-containing solution. In addition, in order to form films by coating method such as spin coating, inkjet and nozzle printing, the viscosity of the solvent is preferably several cP or more.
The compound A (the host of the emitting layer) exhibited relatively favorable solubility in the solvents of Comparatives 1 to 3, 5, 6. However, the solvents are not preferable for the organic electroluminescent material-containing solution because the viscosity of the solvents was low. The compound A exhibited low solubility in the solvents of Comparatives 4, 7, 8, and the solvents of Comparatives 4, 7, 8 exhibited low viscosity. Accordingly, the solvents are not preferable for the organic electroluminescent material-containing solution. Although the solvent of the Comparative 9 exhibited high viscosity, the compound A exhibited low solubility in the solvent of Comparative 9. Accordingly, the solvent is not preferable for the organic electroluminescent material-containing solution.
In contrast, the compound A exhibited relatively favorable solubility in biphenyl derivatives of Examples 1, 2, and the viscosity of biphenyl derivatives was high. Accordingly, the solvents are preferably used as the solvent of the organic electroluminescent material-containing solution.

### (Examples 3 to 8, Comparatives 10 to 16)

An anthracene derivative (compounds B to N below) was added to 4-isopropylbiphenyl by an amount corresponding to 0.5 wt%, solubility of which was evaluated by visual check.
The results are shown in Table 2, where solution that contained no insoluble element is rated as "A" while solution that contained insoluble element(s) is rated as "B".

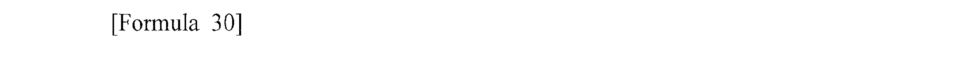

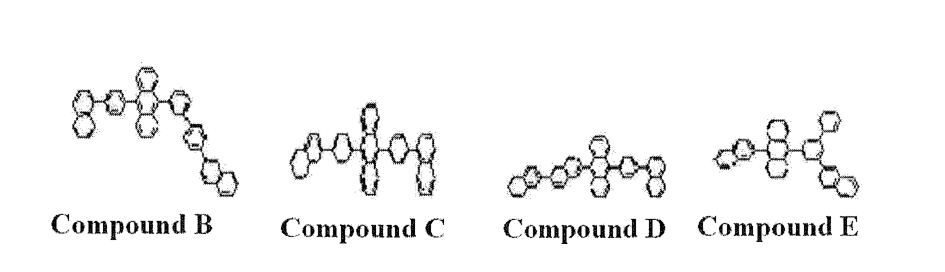

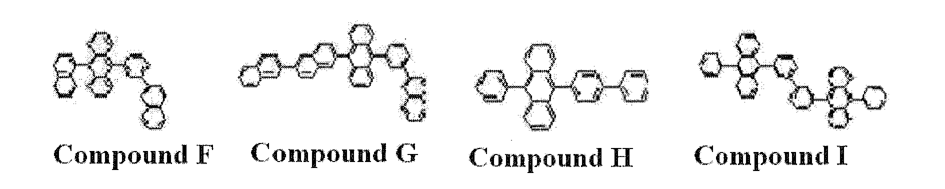

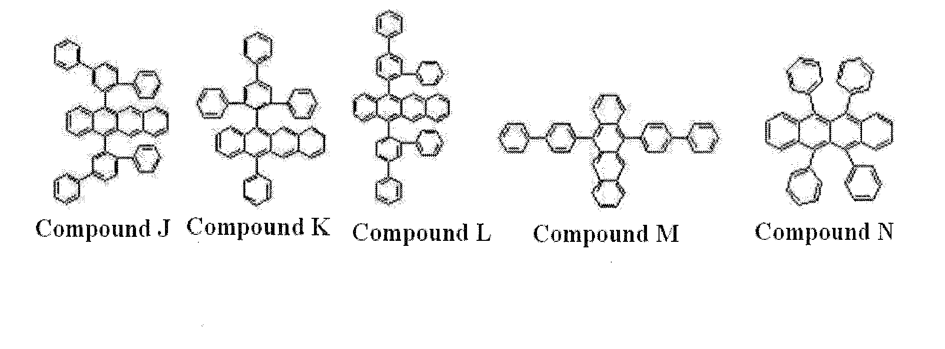

**[Table 2]**

| | Anthracene Derivative (Naphthacene Derivative) | Solubility |
|---|---|---|
| Example 3 | Compound B | A |
| Example 4 | Compound C | A |
| Example 5 | Compound D | A |
| Example 6 | Compound E | A |
| Comparative 10 | Compound F | B |
| Comparative 11 | Compound G | B |
| Comparative 12 | Compound H | B |
| Comparative 13 | Compound I | B |
| Example 7 | Compound J | A |
| Example 8 | Compound K | A |
| Comparative 14 | Compound L | B |
| Comparative 15 | Compound M | B |
| Comparative 16 | Compound N | B |

As is understood from Examples 3 to 6 and Comparatives 10 to 13, when an anthracene derivative was used as the solute, the compounds F, G where a naphthyl group was bonded to the central anthracene skeleton in meta position with a phenyl group interposed therebetween exhibited low solubility in 4-isopropylbiphenyl. In addition, the compound H where a substituent was attached in para position to a phenyl group bonded to the central anthracene skeleton and the compound I where the central anthracene skeletons were bonded together by biphenylene also exhibited low solubility in 4-isopropylbiphenyl.
As is understood from Examples 7, 8 and Comparatives 14 to 16, when a naphthacene derivative was used as the solute, the compounds L, M having two substituents in para positions exhibited low solubility in 4-isopropylbiphenyl. Further, the compound N having no substituent in para position exhibited lower solubility than the compounds J, K.

### (Examples 9 to 14)

Using the compound A as the host while using a below-shown dopant A as the dopant, the organic electroluminescent material-containing solution was prepared.
The host and the dopant were mixed together by a ratio of 20 to 1 by weight, and solid content was contained in the solvent at a concentration of 0.5 wt%.
The viscosity of the prepared organic electroluminescent material-containing solution is shown in Table 3. The measurement conditions were the same as in Example 1 above.

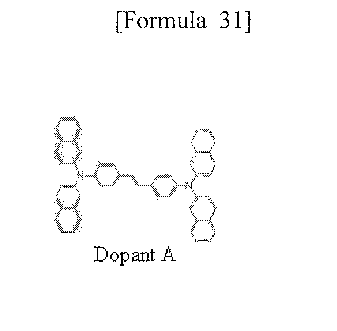

**[Table 3]**

| | Solvent (S) | Viscosity Control Reagent (V) | Mass Ratio (S/V) | Viscosity (cP) |
|---|---|---|---|---|
| Example 9 | 4-isopropylbiphenyl | None | 100/0 | 6.9 |
| Example 10 | 4-isopropylbiphenyl | 1,1-bis(3,4-dimethyl phenyl)ethane | 75/25 | 8.9 |
| Example 11 | 4-isopropylbiphenyl | Toluene | 95/5 | 5.2 |
| Example 12 | 3-ethylbiphenyl | None | 100/0 | 5.6 |
| Example 13 | 3-ethylbiphenyl | 1,1-bis(3,4-dimethyl phenyl)ethane | 75/25 | 7.0 |
| Example 14 | 3-ethylbiphenyl | Toluene | 98/2 | 5.1 |

Comparisons between Examples 9 and 10 and between Examples 12 and 13 have revealed that 1,1-bis(3,4-dimethyl phenyl)ethane serves as a viscosity control reagent to enhance the viscosity.
On the other hand, comparisons between Examples 10 and 11 and between Examples 13 and 14 have revealed that toluene serves as a viscosity control reagent to lower the viscosity.

### (Examples 15 to 19)

Using the compound J as the host while using a below-shown dopant B as the dopant, the organic electroluminescent material-containing solution was prepared.
The host and the dopant were mixed together by a ratio of 20 to 1 by weight, and solid content was contained in the solvent at a concentration of 0.5 wt%.
The viscosity of the prepared organic electroluminescent material-containing solution is shown in Table 4. The measurement conditions were the same as in Example 1 above.

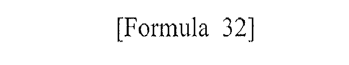

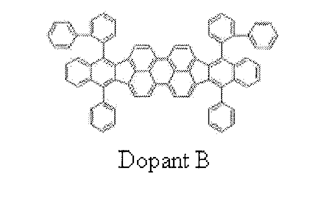

**[Table 4]**

| | Solvent(S) | Viscosity Control Reagent (V) | Mass Ratio (S/V) | Viscosity (cP) |
|---|---|---|---|---|
| Example 15 | 4-isopropylbiphenyl | None | 100/0 | 6.9 |
| Example 16 | 4-isopropylbiphenyl | 1,1-bis(3,4-dimethyl phenyl)ethane | 75/25 | 8.9 |
| Example 17 | 4-isopropylbiphenyl | Toluene | 95/5 | 5.2 |
| Example 18 | 3-ethylbiphenyl | None | 100/0 | 5.6 |
| Example 19 | 3-ethylbiphenyl | Toluene | 98/2 | 5.1 |

As is understood from Table 4, Examples 15 to 19 exhibited the same tendency as Examples 9 to 14. Specifically, it can be understood that the material (blue-emitting material) used in Examples 9, 10 and the material (red-emitting material) used in Examples 15 to 19 exhibit the same viscosity tendency.

### (Examples 20 to 28, Comparative 17)

Manufacturing examples of the organic electroluminescence device will be described below.

**[Table 5]**

| | Host/Dopant (weight ratio) | Solvent (weigh ratio) | Solid Content Concentration | Viscosity (cP) | Inkjet Ejection |
|---|---|---|---|---|---|
| Example 20 | | 4-isopropylbiphenyl /cyclohexanol (75/25) | | 8.2 | Stably ejected |
| Comparative 17 | Compound A /Dopant A (20/1) | isopropylbenzene /cyclohexanol (75/25) | | 2.3 | Not stably ejected |
| Example 21 | | 3-ethylbiphenyl /cyclohexanol (75/25) | | 6.5 | |
| Example 22 | Compund E /Dopant A (20/1) | | | 8.3 | |
| Example 23 | Compound A /EM144 (20/1) | | 0.5 | 8.3 | |
| Example 24 | Compound A /EM145 (20/1) | | wt% | 8.4 | |
| Example 25 | Compound A /EM151 (20/1) | 4-isopropylbiphenyl /cyclohexanol (75/25) | | 8.3 | Stably ejected |
| Example 26 | Compound A /EM131 (20/1) | | | 8.3 | |
| Example 27 | Compound A /EM195 (20/1) | | | 8.4 | |
| Example 28 | Compuond J /Dopant B (100/1) | | | 8.3 | |

### (Examples 20: Manufacturing of Blue-Emitting Device)

### (1) Preparation of Organic Electroluminescent Material-Containing Solution

An organic electroluminescent material containing the compound A (host) and the dopant A (dopant) by a weight ratio of 20 to 1 was dissolved in a solvent containing 4-isopropylbiphenyl and cyclohexanol by a weight ratio of 75 to 25, so that a solid content of the material was contained in the solvent at a concentration of 0.5 wt%. The viscosity of the solution was 8.2cP.

### (2) Forming Organic Electroluminescent Thin Film(s)

Using a commercially-available inkjet device (manufacturer: Dimatix, Inc., product type: DMP-2381, inkjet head: 10 pl (DMC-11610)), the organic electroluminescent material-containing solution prepared in the above (1) was ejected on a glass substrate (manufactured by Geomatec Co., LTD.). Using an optical camera, ejection processes were observed from a direction orthogonal to a line connecting the inkjet and the substrate. A droplet formed by the inkjet head was ejected onto a spot of the substrate immediately below the head, thereby forming a film. No droplet was ejected onto any other spot of the substrate than the spot immediately below the head, and the ejection was stable.
Then, drying was performed at 120 degrees C for 30 minutes. While observing the substrate with an optical microscope, formation of a film corresponding to the droplet was observed. The film had a diameter of 100µm and a thickness of 20nm.

### (3) Manufacturing and Evaluation of Organic Electroluminescence Device

A glass substrate (size: 25 mm x 75 mm x 1.1 mm thick) having an ITO transparent electrode (manufactured by Geomatics) was ultrasonic-cleaned in isopropyl alcohol for five minutes, and then UV (ultraviolet) /ozone-cleaned for 30 minutes.
Polyethylene-dioxy-thiophene · polystyrene sulphonic acid (PEDOT·PSS) for forming the hole injecting layer was deposited on the cleaned substrate having the ITO transparent electrode by spin coating to form a 50nm-thick film. Then, the formed film was dried on a hot plate at 200 degrees C for 15 minutes.
Subsequently, the substrate was put in a glove box in which concentration of oxygen and water was maintained to be 1 ppm or less, and again dried at 200 degrees C for 15 minutes.
A 20nm-thick film was formed from a toluene solution (concentration of solid content: 0.6 wt%) of below-described Polymer 1 (Mw: 145000) by spin coating and dried at 170 degrees C for 30 minutes.

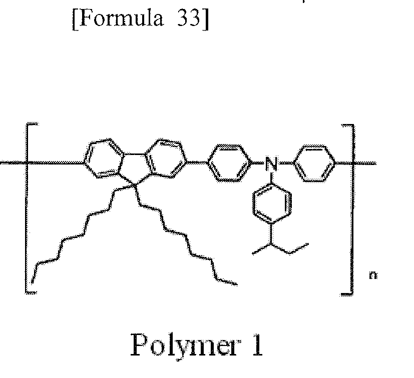

Subsequently, using the inkjet device, a 40nm-thick film was formed from the organic electroluminescent material-containing solution. The film was then dried on a hot plate at 120 degrees C for 30 minutes.
The substrate was transferred to a vacuum-deposition chamber via a chamber connected to the glove box. A 20nm-thick film of tris(8-quinolinol) aluminum (the electron injecting layer) was deposited on the substrate, 0.5nm-thick LiF (an inorganic film) was further deposited thereon, and a 100nm-thick film of aluminum (the cathode) was deposited thereon, thereby forming an organic electroluminescence device. Vacuum when each layer was deposited was 10 to 5 Pa.
The luminous performance of the manufactured organic electroluminescence device and time elapsed until the luminescence intensity decreased to half when the device was driven by DC constant current at a room temperature with the initial luminescence intensity being 1000cd/m² while the luminous efficiency being 5.1cd/A were 4000 hours.

### (Comparative 17)

An organic electroluminescent material containing the compound A (host) and the dopant A (dopant) by a weight ratio of 20 to 1 was dissolved in a solvent containing isopropylbenzene and cyclohexanol by a weight ratio of 75 to 25, so that a solid content of the material was contained in the solvent at a concentration of 0.5 wt%. The viscosity of the solution was 2.3cP.
The prepared solution was ejected using the same inkjet device as in Example 20. While observing the ejection processes, a droplet ejected on the spot of the substrate immediately below the head and a droplet whose flying shape was disturbed to be ejected on a spot other than the spot immediately below the head were observed. The ejection was not stable.

### (Examples 21: Manufacturing of Blue-Emitting Device)

In preparing organic electroluminescent material-containing solution, an organic electroluminescent material containing the compound A (host) and the dopant A (dopant) by a weight ratio of 20 to 1 was dissolved in a solvent containing 3-ethylbiphenyl and cyclohexanol by a weight ratio of 75 to 25, so that a solid content of the material was contained in the solvent at a concentration of 0.5 wt%. The viscosity of the solution was 6.5cP. Film forming by inkjet was conducted in the same manner as Example 20.
The inkjet ejection was the same as Example 20.

### (Example 22: Manufacturing of Blue-Emitting Device)

In preparing organic electroluminescent material-containing solution, an organic electroluminescent material containing the compound E (host) and the dopant A (dopant) by a weight ratio of 20 to 1 was dissolved in a solvent containing 4-isopropylbiphenyl and cyclohexanol by a weight ratio of 75 to 25, so that a solid content of the material was contained in the solvent at a concentration of 0.5 wt%. The viscosity of the solution was 8.3cP. Film forming by inkjet was conducted in the same manner as Example 20.
The inkjet ejection was the same as Example 20.

### (Example 23: Manufacturing of Green-Emitting Device)

In preparing organic electroluminescent material-containing solution, an organic electroluminescent material containing the compound A (host) and the compound EM144 (dopant) by a weight ratio of 20 to 1 was dissolved in a solvent containing 4-isopropylbiphenyl and cyclohexanol by a weight ratio of 75 to 25, so that a solid content of the material was contained in the solvent at a concentration of 0.5 wt%. The viscosity of the solution was 8.3cP. Film forming by inkjet was conducted in the same manner as Example 20.
The inkjet ejection was the same as Example 20.

### (Examples 24 to 27: Manufacturing of Green-Emitting Device)

As the organic electroluminescent materials, the dopants shown in Table 5 were used in the Examples. The host, the solvent, the weight ratio of the solvent and the concentration of solid content in each Example were the same as in Example 23 above. The viscosity of the solutions according to Examples 24 and 27 respectively was 8.4cP. The viscosity of the solutions according to Examples 25 and 26 respectively was 8.3cP.
The inkjet ejection was the same as Example 20.

### (Example 28: Red-Emitting Device)

In preparing organic electroluminescent material-containing solution, an organic electroluminescent material containing the compound J (host) and the dopant B (dopant) by a weight ratio of 100 to 1 was dissolved in a solvent containing 4-isopropylbiphenyl and cyclohexanol by a weight ratio of 75 to 25, so that a solid content of the material was contained in the solvent at a concentration of 0.5 wt%. The viscosity of the solution was 8.3cP. Film forming by inkjet was conducted in the same manner as Example 20.
The inkjet ejection was the same as Example 20.

### INDUSTRIAL APPLICABILITY

This invention can be used for providing an organic electroluminescent material-containing solution applicable to forming film(s) of a high-performance organic electroluminescent material by coating method and for providing a method of forming organic electroluminescent thin film(s) using the organic electroluminescent material-containing solution.

## Claims

1. An organic electroluminescent material-containing solution, comprising:
an organic electroluminescent material; and
a solvent, wherein
the organic electroluminescent material at least comprises a host and a dopant,
the host is an anthracene derivative, and
the host is dissolved in the solvent with a content of 0.5 weight percent or more while the solvent exhibits viscosity of 5cP or more.

2. The organic electroluminescent material-containing solution according to Claim 1, wherein the solvent comprises a biphenyl derivative.

3. The organic electroluminescent material-containing solution according to Claim 2, wherein the solvent comprises alkyl-substituted biphenyl having an alkyl group as a substituent, the alkyl group having 1 to 10 carbon atoms.

4. The organic electroluminescent material-containing solution according to Claim 3, wherein the alkyl group of the alkyl-substituted biphenyl has 1 to 5 carbon atoms.

5. The organic electroluminescent material-containing solution according to any one of Claims 1 to 4, wherein the host has a molecular weight of 4000 or less.

6. The organic electroluminescent material-containing solution according to any one of Claims 1 to 5, wherein the anthracene derivative is represented by a formula (1) as follows, 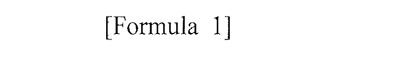 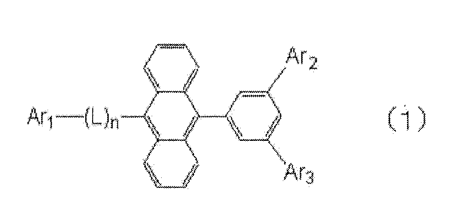 where: Ar₁ to Ar₃ each represent a substituted or unsubstituted aryl group having 5 to 50 atoms forming the ring, a substituted or unsubstituted heteroaryl having 5 to 50 atoms forming the ring, or a fused aromatic group having 10 to 30 carbon atoms;
L represents a single bond, a divalent linking group, the divalent linking group being a substituted or unsubstituted arylene group having 5 to 50 atoms forming the ring, or a substituted or unsubstituted heteroarylene group having 5 to 50 atoms forming the ring; and
n represents an integer of 1 to 4.

7. The organic electroluminescent material-containing solution according to any one of Claims 1 to 5, wherein the anthracene derivative is represented by a formula (2) as follows, 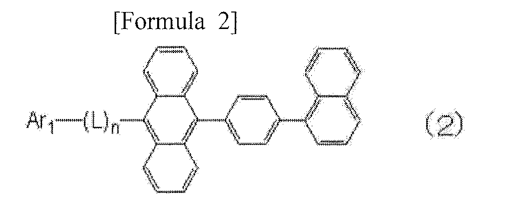 where: Ar₁ represents a substituted or unsubstituted aryl group having 5 to 50 atoms forming the ring or a substituted or unsubstituted heteroaryl having 5 to 50 atoms forming the ring;
L represents a divalent linking group, the divalent linking group being a substituted or unsubstituted arylene group having 5 to 50 atoms forming the ring, a substituted or unsubstituted heteroarylene group having 5 to 50 atoms forming the ring, or a fused aromatic group having 10 to 30 carbon atoms; and
n represents an integer of 0 to 4.

8. The organic electroluminescent material-containing solution according to Claim 6 or 7, wherein n in the formula (1) is an integer in a range of 0 to 2.

9. The organic electroluminescent material-containing solution according to Claim 1, wherein a naphthacene derivative represented by a formula (3) as follows is used as the host in place of the anthracene derivative, 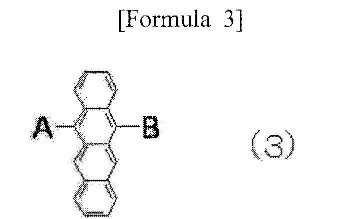 where: A and B each represent a substituted or unsubstituted aromatic group having 6 to 20 carbon atoms or a substituted or unsubstituted fused aromatic group having 10 to 20 carbon atoms, A and B being allowed to be mutually the same or different on a condition that at least either one of A and B has a structure represented by a formula (4) as follows, 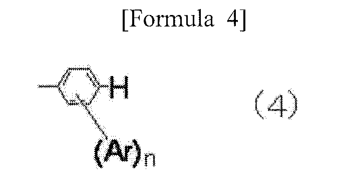 where: Ar represents a substituted or unsubstituted aromatic group having 6 to 20 carbon atoms or a substituted or unsubstituted fused aromatic group having 10 to 20 carbon atoms; and n represents an integer in a range of 0 to 4.

10. The organic electroluminescent material-containing solution according to any one of Claims 1 to 8, wherein the dopant is a styrylamine derivative represented by a formula (5) as follows, 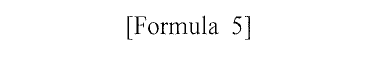 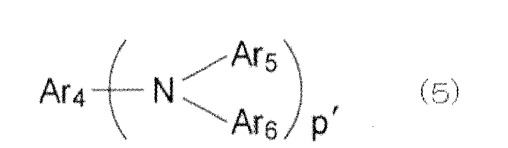 where: at least one of Ar₄ to Ar₆ has a substituted or unsubstituted styryl group; and p' is an integer in a range of 1 to 4.

11. The organic electroluminescent material-containing solution according to Claim 10, wherein a substituted derivative of arylamine represented by a formula (6) as follows is used as the dopant in place of the styrylamine derivative represented by the formula (5), 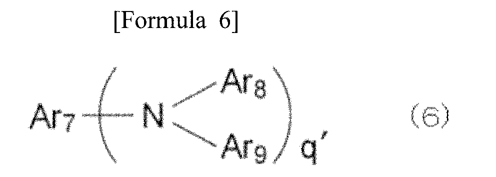 where: Ar₇ to Ar₉ each represent a substituted or unsubstituted aryl group having 5 to 40 carbon atoms forming the aromatic ring; and
q' represents an integer in a range of 1 to 4.

12. The organic electroluminescent material-containing solution according to Claim 9, wherein the dopant is an indenoperylene derivative represented by a formula (7) as follows, 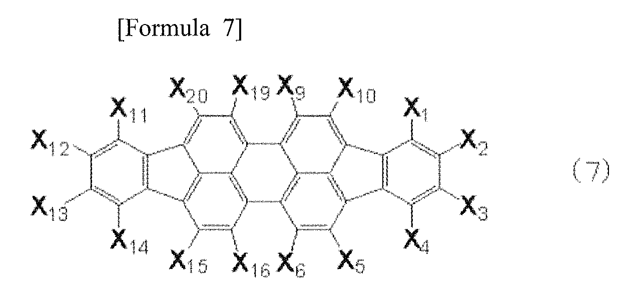 where: X₁ to X₆, X₉, X₁₀, X₁₁ to X₁₆, X₁₉ and X₂₀ each represent a hydrogen atom, a halogen atom, an alkyl group, an alkoxy group, an alkylthio group, an alkenyl group, an alkenyloxy group, an alkenylthio group, an aromatic ring-containing alkyl group, an aromatic ring-containing alkyloxy group, an aromatic ring-containing alkylthio group, an aromatic ring group, an aromatic heterocyclic group, an aromatic-ring oxy group, an aromatic-ring thio group, an aromatic-ring alkenyl group, an alkenyl aromatic ring group, an amino group, a carbazolyl group, a cyano group, a hydroxyl group, -COOR^{1'} (R^{1'} represents a hydrogen atom, an alkyl group, an alkenyl group, an aromatic ring-containing alkyl group or an aromatic ring group), -COR^{2'} (R^{2'} represents a hydrogen atom, an alkyl group, an alkenyl group, an aromatic ring-containing alkyl group, an aromatic ring group or an amino group) or -OCOR^{3'} (R^{3'} represents an alkyl group, an alkenyl group, an aromatic ring-containing alkyl group or an aromatic ring group);
an adjacent set of X₁ to X₆, X₉, X₁₀, X₁₁ to X₁₆, X₁₉ and X₂₀ is allowed to be mutually bonded to form a cyclic structure or is allowed to form a cyclic structure together with substituting carbon atoms; and
at least one of X₁ to X₆, X₉, X₁₀, X₁₁ to X₁₆, X₁₉ and X₂₀ is not a hydrogen atom.

13. The organic electroluminescent material-containing solution according to Claim 12, wherein the indenoperylene derivative is represented by a formula (8) as follows, 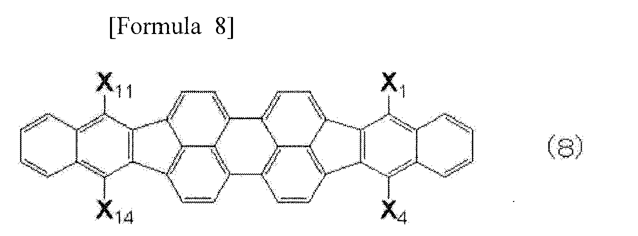 where X₁, X₄, X₁₁, X₁₄ each represent an aromatic ring group.

14. The organic electroluminescent material-containing solution according to any one of Claims 1 to 13, further comprising a viscosity control reagent.

15. A method of forming organic electroluminescent thin film(s) for forming thin film(s) of an organic electroluminescent material using an organic electroluminescent material-containing solution according to any one of Claims 1 to 14.

16. The method of forming organic electroluminescent thin film(s) according to Claim 15, the method comprising:
ejecting the organic electroluminescent material-containing solution by inkjet method; and
forming film(s) of the organic electroluminescent material by volatilizing the solvent from the ejected organic electroluminescent material-containing solution.

17. An organic electroluminescence device, comprising the organic electroluminescent thin film(s) formed by the method of forming organic electroluminescent thin film(s) according to Claim 15 or 16.
